# EUROPEAN PATENT APPLICATION

(11) **EP 4 300 189 A1**
(43) Date of publication of application: **03.01.2024**
(21) Application number: 22780942.3
(22) Date of filing: 29.03.2022
(51) Int. Cl.: G03F 1/62

(54) **PELLICLE, ORIGINAL PLATE FOR LIGHT EXPOSURE, LIGHT EXPOSURE DEVICE, METHOD FOR PRODUCING PELLICLE, AND METHOD FOR PRODUCING SEMICONDUCTOR DEVICE**

(30) Priority: 31.03.2021 JP 2021061642
(71) Applicant: Mitsui Chemicals, Inc., Tokyo 104-0028 (JP)
(72) Inventor: ONO, Yousuke, Sodegaura-shi, Chiba 299-0265 (JP)
(74) Representative: Hoffmann Eitle
(86) International application number: PCT/JP2022/015525
(87) International publication number: WO 2022/210731

(57) **Abstract**

To provide a pellicle in which breakage of a pellicle film due to the pressure difference inside and outside of the pellicle can be suppressed. A pellicle (10A) includes a support frame (12A) having an opening (H12A), and a pellicle film (11A). The pellicle film has a self-supporting film region (RA) covering an opening. The self-supporting film region contains an exposing region (RA1) and a peripheral border region (RA2) surrounding the exposing region. The peripheral border region contains a thick film portion (TA) having a thicker film thickness than a film thickness of the exposing region. The pellicle satisfies the following (i) or (ii):
(i) the support frame is a rectangular frame, and the thick film portion is at least located in a pair of predetermined longer side regions, in the peripheral border region; and
(ii) the support frame is a square frame, and the thick film portion is at least located in a pair of predetermined first center regions and a pair of predetermined second center regions, in the peripheral border region.

## Description

### Technical Field

The present disclosure relates to a pellicle, an exposure original plate, an exposure device, a method of producing a pellicle, and a method of producing a semiconductor device.

### Background Art

Transparent substrates called photomasks in which patterns are formed on one surface are used in pattern formation techniques (photolithography) including applying photosensitive substances to surfaces of objects such as electronic components, print substrates, or display panels, and performing exposure in patterns.

In recent years, as high definition of exposure patterns has progressed, EUV (Extreme Ultra Violet) light of shorter wavelengths has been increasingly utilized in light sources for exposure, instead of DUV (Deep Ultra Violet) light. Photomasks provided with reflection layers reflecting exposure light are used in exposure methods using EUV light. Photomasks are provided with pellicles mounted for preventing foreign substances such as grit and dust from being attached onto surfaces of photomasks.

Patent Literature 1 discloses a pellicle. The pellicle disclosed in Patent Literature 1 includes a specified pellicle film and a support frame supporting the pellicle film. The support frame has an opening. The pellicle film covers the opening of the support frame.

Patent Literature 1: WO 2018/008594

### SUMMARY OF INVENTION

### Technical Problem

EUV light is easily absorbed by gas such as oxygen or nitrogen. Therefore, exposure by EUV light (hereinafter, also referred to as "EUV exposure") is carried out under a vacuum environment.

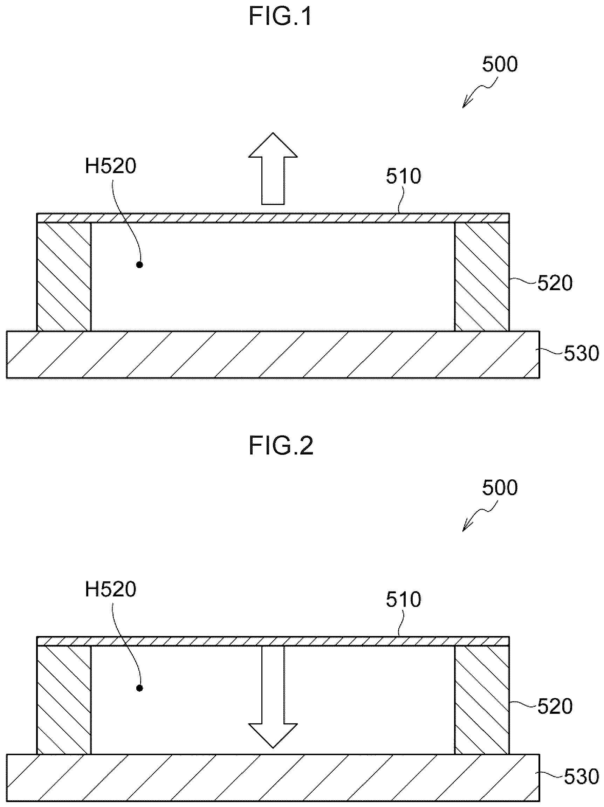

In a case in which EUV exposure is started, the entire exposure device is vacuumed. An environment in which a pellicle placed in the exposure device is placed is also turned from an atmospheric pressure environment to a vacuum environment. The vacuuming speed of the exposure device is high. Specifically, even in a case in which a vent hole is formed on a support frame for suppression of the pressure difference inside and outside of the pellicle, the rate of reduction in atmospheric pressure of the outside of the pellicle is higher than the rate of reduction in atmospheric pressure of the inside of the pellicle. Therefore, as illustrated in FIG. 1, a pellicle film 510 is pushed from an inside of the pellicle 500 toward an outside of the pellicle 500. In FIG. 1, an arrow indicates a direction from the inside of the pellicle 500 to the outside of the pellicle 500, 530 represents a photomask, and H520 represents an opening.

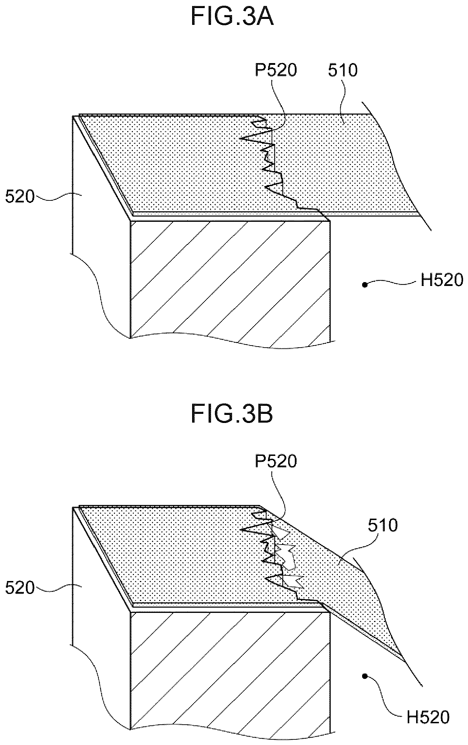

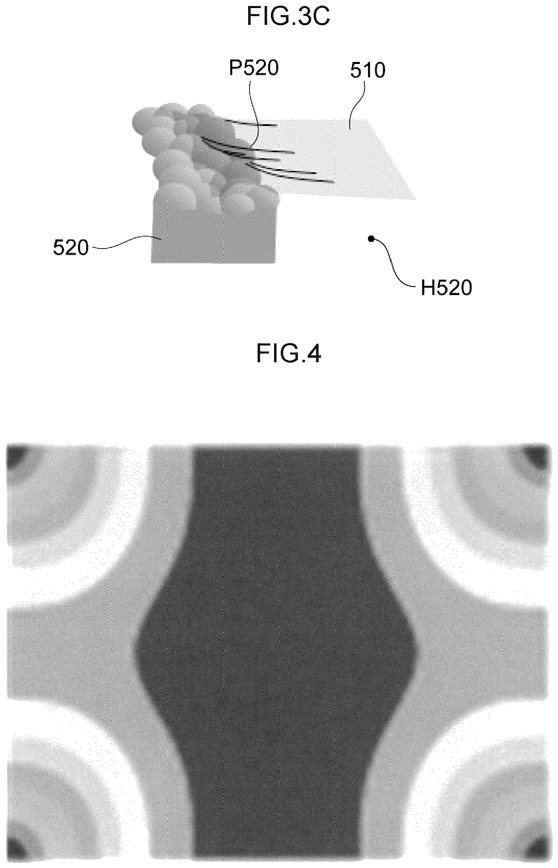

In this regard, in a case in which EUV exposure is terminated, an environment to which the entire exposure device is released is turned from vacuum to atmospheric pressure. The pressure of the outside of the pellicle is rapidly higher than the pressure of the inside of the pellicle. Therefore, a phenomenon reverse to that of vacuuming occurs in the pellicle. Particularly, as illustrated in FIG. 2, the pellicle film 510 is pushed toward the inside of the pellicle 500 from the outside of the pellicle 500. In FIG. 2, an arrow indicates a direction from the outside of the pellicle 500 to the inside of the pellicle 500, 530 represents a photomask, and H520 represents an opening. In a case in which the pellicle film 510 is pushed toward the inside of the pellicle 500, a problem is that stress is easily concentrated at a site of the pellicle film 510, the site facing a peripheral border P520 of an opening H520 of a support frame 520, and the pellicle film 510 is easily broken, as illustrated in FIG. 3A to FIG. 3C.

The disclosure has been made in view of the above circumstances.

An object to be achieved by one embodiment of the disclosure is to provide a pellicle, an exposure original plate, and an exposure device, in which breakage of a pellicle film due to the pressure difference inside and outside of the pellicle can be suppressed.

An object to be achieved by another embodiment of the disclosure is to provide a method of producing a pellicle and a method of producing a semiconductor device, in which breakage of a pellicle film due to the pressure difference inside and outside of the pellicle can be suppressed.

### Solution to Problem

Solutions for solving the above problems encompass the following aspects.
<1> A pellicle comprising:
   a support frame having an opening; and
   a pellicle film that covers the opening and that is supported by the support frame, wherein:
      the pellicle film has a self-supporting film region covering the opening,
      the self-supporting film region contains an exposing region and a peripheral border region surrounding the exposing region,
      the peripheral border region has a thick film portion having a thicker film thickness than a film thickness of the exposing region, and
      the following (i) or (ii) is satisfied:
         (i) the support frame is a rectangular frame formed by a pair of longer side portions and a pair of shorter side portions,
            the thick film portion is located in at least a pair of longer side regions formed along the longer side portions, in the peripheral border region, in an extending direction in which the longer side portions extend, and
            the pair of longer side regions is a region between two locations apart by a distance representing at least 5% of a length. in the opening, of each of the longer side portions, toward each of one direction and another direction from a center portion of each of the longer side portions in the extending direction, in the peripheral border region;
         (ii) the support frame is a square frame formed from a pair of first side portions and a pair of second side portions,
            the thick film portion is, in the peripheral border region, located in at least:
               a pair of first center regions formed along the first side portions in a first extending direction in which the first side portions extend, and
               a pair of second center regions formed along the second side portions in a second extending direction in which the second side portions extend;
            the pair of first center regions is a region between two locations apart by a distance representing at least 5% of a length, in the opening, of each of the first side portions, toward each of one direction and another direction from a center portion of each of the first side portions in the first extending direction, in the peripheral border region, and
            the pair of second center regions is a region between two locations apart by a distance representing at least 5% of a length, in the opening, of each of the second side portions, toward each of one direction and another direction from a center portion of each of the second side portions in the second extending direction, in the peripheral border region.
<2> The pellicle according to <1>, wherein (i) is satisfied.
<3> The pellicle according to <1>, wherein (ii) is satisfied.
<4> The pellicle according to any one of <1> to <3>, wherein the film thickness of the thick film portion is from 1.5 times to 100 times the film thickness of the exposing region.
<5> The pellicle according to any one of <1> to <4>, wherein the pellicle film comprises a carbon nanotube.
<6> The pellicle according to any one of <1> to <5>, wherein the support frame is in contact with the pellicle film.
<7> The pellicle according to any one of <1> to <6>, wherein:
   the pellicle film contains a first film portion having no through-hole, and a second film portion having no film portion in a region corresponding to the exposing region,
   the first film portion contains a first CNT layer containing a carbon nanotube,
   the second film portion contains a second CNT layer containing a carbon nanotube, and
   a total thickness of the first CNT layer and the second CNT layer in the thick film portion is from 1.5 times to 100 times a thickness of the first CNT layer in the exposing region.
<8> The pellicle according to <7>, wherein the second film portion is layered on a surface of the first film portion, the surface being in a region corresponding to the thick film portion of the first film portion and being at an opposite side of the first film portion from the support frame.
<9> An exposure original plate, comprising:
   an original plate; and
   the pellicle according to any one of <1> to <8>, mounted on the original plate.
<10> An exposure device comprising:
   a light source that emits exposure light;
   the exposure original plate according to <9>; and
   an optical system that guides the exposure light emitted from the light source, to the exposure original plate,
   wherein the exposure original plate is placed so that the exposure light emitted from the light source penetrates the pellicle film and the original plate is irradiated with the exposure light.
<11> The exposure device according to <10>, wherein the exposure light is EUV light.
<12> A method of producing the pellicle according to any one of <1> to <8>, comprising:
   a step of preparing the support frame;
   a step of preparing the pellicle film; and
   a connection step of connecting the support frame to the pellicle film.
<13>The method of producing the pellicle according to <12>, wherein:
   the pellicle film contains a carbon nanotube, and
   the thick film portion is formed by a spray coating method or an ink-jet method, in the step of preparing the pellicle film.
<14> A method of producing the pellicle according to any one of <1> to <8>, comprising:
   a step of preparing the support frame;
   a step of preparing a first film;
   a step of preparing a second film;
   a connection step of connecting the support frame to a portion of one main surface of the first film; and
   a layering step of layering the second film on another main surface of the first film, to form the pellicle film.
<15> The method of producing the pellicle according to <14>, wherein each of the first film and the second film comprises a carbon nanotube.
<16> The method of producing the pellicle according to any one of <12> to <15>, wherein the pellicle film comprises a layered film in which two or more CNT films each including a carbon nanotube are layered.
<17> A method of producing a semiconductor device, comprising:
   a step of allowing exposure light emitted from a light source to penetrate the pellicle film of the exposure original plate according to <9>, to irradiate the original plate with the exposure light and reflect the exposure light by the original plate; and
   a step of allowing the exposure light reflected by the original plate to penetrate the pellicle film, to irradiate a sensitive substrate with the exposure light, thereby exposing the sensitive substrate in a pattern shape.
<18> A pellicle comprising:
   a support frame having an opening; and
   a pellicle film that covers the opening and that is supported by the support frame, wherein
   the pellicle film has a self-supporting film region covering the opening,
   the self-supporting film region contains an exposing region and a peripheral border region surrounding the exposing region, and
   a film thickness of the peripheral border region is thicker than a film thickness of the exposing region.
<19> The pellicle according to <18>, wherein the film thickness of the peripheral border region is from 1.5 times to 100 times the film thickness of the exposing region.
<20> The pellicle according to <18> or <19>, wherein the film thickness of the exposing region is from 2 nm to 40 nm.
<21> The pellicle according to any one of <18> to <20>, wherein the pellicle film comprises a carbon nanotube.
<22> The pellicle according to any one of <18> to <21>, wherein the support frame is in contact with the pellicle film.
<23> A method of producing the pellicle according to any one of <18> to <22>, comprising:
   a step of preparing the support frame;
   a step of preparing the pellicle film; and
   a connection step of connecting the support frame to the pellicle film.
<24> The method of producing the pellicle according to <23>, wherein
   the pellicle film contains a carbon nanotube, and
   the thick film portion is formed by a spray coating method or an ink-jet method, in the step of preparing the pellicle film.
<25> A method of producing the pellicle according to any one of <18> to <22>, comprising:
   a step of preparing the support frame;
   a step of preparing a first film;
   a step of preparing a second film;
   a connection step of connecting the support frame to a portion of one main surface of the first film; and
   a layering step of layering the second film on another main surface of the first film, to form the pellicle film.
<26> The method of producing the pellicle according to <25>, wherein each of the first film and the second film comprises a carbon nanotube.
<27> The method of producing the pellicle according to any one of <23> to <26>, wherein the pellicle film comprises a layered film in which two or more CNT films each including a carbon nanotube are layered.

### Advantageous Effects of Invention

One embodiment of the disclosure can provide a pellicle, an exposure original plate, and an exposure device, in which breakage of a pellicle film due to the pressure difference inside and outside of the pellicle can be suppressed.

Another embodiment of the disclosure can provide a method of producing a pellicle and a method of producing a semiconductor device, in which breakage of a pellicle film due to the pressure difference inside and outside of the pellicle can be suppressed.

### BRIEF DESCRIPTION OF DRAWINGS

[FIG. 1] FIG. 1 is a schematic view for describing the change of a conventional pellicle in the change of an interior of an exposure device from an atmospheric pressure state to a vacuum state.
[FIG. 2] FIG. 2 is a schematic view for describing the change of a conventional pellicle in the change of an interior of an exposure device from a vacuum state to an atmospheric pressure state.
[FIG. 3A] FIG. 3A is a schematic view representing one example of an edge portion inside a conventional pellicle, of a support frame in an atmospheric pressure state before vacuuming.
[FIG. 3B] FIG. 3B is a schematic view representing one example of an edge portion inside a conventional pellicle, of a support frame, in the change of environment in which a pellicle is disposed after exposure, from a vacuum environment to an atmospheric pressure environment.
[FIG. 3C] FIG. 3C is a schematic view representing another example of an edge portion inside a conventional pellicle, of a support frame, in the change of environment in which a pellicle is disposed after exposure, from a vacuum environment to an atmospheric pressure environment.
[FIG. 4] FIG. 4 is a top view of a pellicle, illustrating stress distribution simulation results at a differential pressure of 3 Pa onto a pellicle film in the case of a support frame of a rectangular shape.
[FIG. 5] FIG. 5 is a top view illustrating an appearance of a pellicle according to a first embodiment of the disclosure.
[FIG. 6] FIG. 6 is a cross-sectional view on a V-V-line of FIG. 5.
[FIG. 7] FIG. 7 is a schematic top view of a microscope image obtained by imaging a portion of a peripheral border of an opening from above a pellicle film of the pellicle according to the first embodiment of the disclosure.
[FIG. 8A] FIG. 8A is an illustration diagram for describing a method of transferring a self-supporting film region of the pellicle film according to the first embodiment of the disclosure, onto a silicon substrate.
[FIG. 8B] FIG. 8B is an illustration diagram for describing a method of transferring a self-supporting film region of the pellicle film according to the first embodiment of the disclosure, onto a silicon substrate.
[FIG. 9A] FIG. 9A is a top view of a silicon substrate onto which a site corresponding to the self-supporting film region of the pellicle film according to the first embodiment of the disclosure is transferred.
[FIG. 9B] FIG. 9B is a cross-sectional view on an IXB-IXB-line of FIG. 9A.
[FIG. 10] FIG. 10 is a cross-sectional of a pellicle according to a variation of the first embodiment of the disclosure.
[FIG. 11] FIG. 11 is a schematic cross-sectional view of an EUV exposure device as an exposure device according to the first embodiment of the disclosure.
[FIG. 12] FIG. 12 is a top view illustrating an appearance of a pellicle according to a second embodiment of the disclosure.
[FIG. 13] FIG. 13 is a top view illustrating an appearance of a pellicle according to a third embodiment of the disclosure.
[FIG. 14A] FIG. 14A is an illustration diagram for describing a method of producing a pellicle of Example 1.
[FIG. 14B] FIG. 14B is an illustration diagram for describing a method of producing a pellicle of Example 1.
[FIG. 14C] FIG. 14C is an illustration diagram for describing a method of producing a pellicle of Example 1.
[FIG. 15] FIG. 15 is a cross-sectional view of the pellicle of Example 1.
[FIG. 16A] FIG. 16A is a schematic view illustrating a measurement apparatus in a bulge test.
[FIG. 16B] FIG. 16B is a graph representing the pressure difference inside and outside of a pellicle relative to a lapse time in a bulge test.
[FIG. 17A] FIG. 17A is an illustration diagram for describing a method of producing a pellicle of Example 2.
[FIG. 17B] FIG. 17B is an illustration diagram for describing a method of producing a pellicle of Example 2.
[FIG. 18] FIG. 18 is a cross-sectional view of the pellicle of Example 1.

### DESCRIPTION OF EMBODIMENTS

A numerical value range represented by "(from) ... to ..." in the disclosure means that numerical values described before and after "to" are encompassed as a lower limit and an upper limit, respectively.

An upper limit value or a lower limit value described with respect to a certain numerical value range as a numerical value range described stepwise in the disclosure may be replaced with an upper limit value or a lower limit value of other numerical value range described stepwise. An upper limit value or a lower limit value described with respect to a certain numerical value range as a numerical value range described in the disclosure may be each replaced with any value represented in Examples.

A combination of two or more preferable aspects in the disclosure is a more preferable aspect.

In a case in which a plurality of substances corresponding to each component is present in the disclosure, the amount of such each component means the total amount of the plurality of substances present, unless particularly noted.

The term "step" herein encompasses not only an independent step, but also a step that can achieve a predetermined object even in the case of being not clearly distinguished from other steps.

The pellicle of the disclosure includes a support frame having an opening, and a pellicle film that covers the opening and that is supported by the support frame. The pellicle film has a self-supporting film region covering the opening. The self-supporting film region contains an exposing region and a peripheral border region surrounding the exposing region. The peripheral border region has a thick film portion having a thicker film thickness than the film thickness of the exposing region. The following (i) or (ii) is satisfied:
(i) the support frame is a rectangular frame formed by a pair of longer side portions and a pair of shorter side portions,
   the thick film portion is located in at least a pair of longer side regions formed along the longer side portions, in the peripheral border region, in an extending direction in which the longer side portions extend, and
   the pair of longer side regions is a region between two locations apart by a distance representing at least 5% of the length, in the opening, of each of the longer side portions, toward each of one direction and another direction from a center portion of each of the longer side portions in the extending direction, in the peripheral border region;
(ii) the support frame is a square frame formed from a pair of first side portions and a pair of second side portions,
   the thick film portion is, in the peripheral border region, located in at least:
      a pair of first center regions formed along the first side portions in a first extending direction in which the first side portions extend, and
      a pair of second center regions formed along the second side portions in a second extending direction in which the second side portions extend;
   the pair of first center regions is a region between two locations apart by a distance representing at least 5% of the length, in the opening, of each of the first side portions, toward each of one direction and another direction from a center portion of each of the first side portions in the first extending direction, in the peripheral border region, and
   the pair of second center regions is a region between two locations apart by a distance representing at least 5% of the length, in the opening, of each of the second side portions, toward each of one direction and another direction from a center portion of each of the second side portions in the second extending direction, in the peripheral border region.

In the disclosure, "the thick film portion is located in at least a pair of longer side regions formed along the longer side portions, in the peripheral border region, in an extending direction in which the longer side portions extend" means that the thick film portion may be located in a pair of longer side regions. For example, in a case in which the support frame is a rectangular frame, the thick film portion may be located in the whore area of the peripheral border region, or may be located in a pair of longer side regions, and a portion of a region in which the pair of longer side regions is excluded, in the peripheral border region.

In the disclosure, "the thick film portion is, in the peripheral border region, located in at least a pair of first center regions formed along the first side portions in a first extending direction in which the first side portions extend, and a pair of second center regions formed along the second side portions in a second extending direction in which the second side portions extend" means that the thick film portion may be located in a pair of first center regions and a pair of second center regions. For example, in a case in which the support frame is a square frame, the thick film portion may be located in the whore area of the peripheral border region, or may be located in a pair of first center regions and a pair of second center regions, and a portion of a region in which the pair of first center regions and the pair of second center regions are excluded, in the peripheral border region.

In the disclosure, "the length in the opening, of each of the longer side portions" is the same as the length of the opening of the support frame in the extending direction.

In the disclosure, "the length in the opening, of each of the first side portions" is the same as the length of the opening of the support frame in the first extending direction.

In the disclosure, "the length in the opening, of each of the second side portions" is the same as the length of the opening of the support frame in the second extending direction.

The pellicle of the disclosure has the above configuration, whereby breakage of the pellicle film due to the pressure difference inside and outside of the pellicle can be suppressed. In other words, breakage of the pellicle film due to the pressure difference inside and outside of the pellicle can be suppressed as compared with a pellicle in which the thickness of a pellicle film is uniform.

A conventional pellicle has often contained an adhesive layer between a support frame and a pellicle film, whereby the adhesive layer has prevented the pellicle film and the support frame from being directly contacted and breakage of the pellicle film has hardly occurred.

However, a pellicle using a carbon nanotube-containing film (hereinafter, also referred to as "CNT film") often has a structure in which a support frame and a pellicle film are directly contacted with no adhesive layer being interposed therebetween. Such a CNT film is soft as compared with a conventional film including polysilicon, and easily causes stress concentration due to deformation.

From the foregoing, the above problem of breakage of a pellicle film in a pellicle using a CNT film is more made apparent.

The above problem is further made apparent particularly in a pellicle film designed so as to have a substantially uniform film thickness as in conventional one, in a case in which the pellicle film is thinned in film thickness for an increase in transmittance of the pellicle film.

FIG. 4 illustrates stress distribution simulation results in a pellicle viewed from the top surface, at a differential pressure of 3 Pa onto a pellicle film (application of the differential pressure in a direction in which the pellicle film is pushed toward a support frame), in a case in which the support frame is a rectangular frame. The shape of the pellicle frame is a rectangular shape (length of a pair of shorter side portions (longitudinal): 110 mm, length of a pair of longer side portions (lateral): 143 mm).

It has been found as illustrated in FIG. 4 that stress to the pellicle film, generated due to the pressure difference inside and outside of the pellicle, is the largest near a center portion of a pair of longer side portions of the support frame, in an extending direction in which the longer side portions extend.

In a case in which the support frame is a rectangular frame in the pellicle of the disclosure, the thick film portion is located in a pair of longer side regions. Thus, the pellicle of the disclosure can be suppressed in breakage of the pellicle film due to the pressure difference inside and outside of the pellicle. In particular, the thick film portion is provided so as to step across an edge portion of the support frame in a direction from the peripheral border region toward the support frame, whereby breakage of the pellicle film due to stress concentration to the pellicle film on the edge portion of the support frame can be easily suppressed.

It has been experimentally found that, in a case in which the support frame is a square frame, stress to the pellicle film, generated due to the pressure difference inside and outside of the pellicle, is the largest near a center portion of each of four sides of the support frame.

In a case in which the support frame is a square frame in the pellicle of the disclosure, the thick film portion is located in a pair of first center regions and a pair of second center regions. Thus, the pellicle of the disclosure can be suppressed in breakage of the pellicle film due to the pressure difference inside and outside of the pellicle. In particular, the thick film portion is provided so as to step across an edge portion of the support frame in a direction from the peripheral border region toward the support frame, whereby breakage of the pellicle film due to stress concentration to the pellicle film on the edge portion of the support frame can be easily suppressed.

The transmittance of EUV light can be measured with a photodiode. Specifically, the transmittance of EUV light is represented by the ratio of the current value detected in a state in which the pellicle film is disposed, to the current value detected in a state in which the pellicle film is not detected.

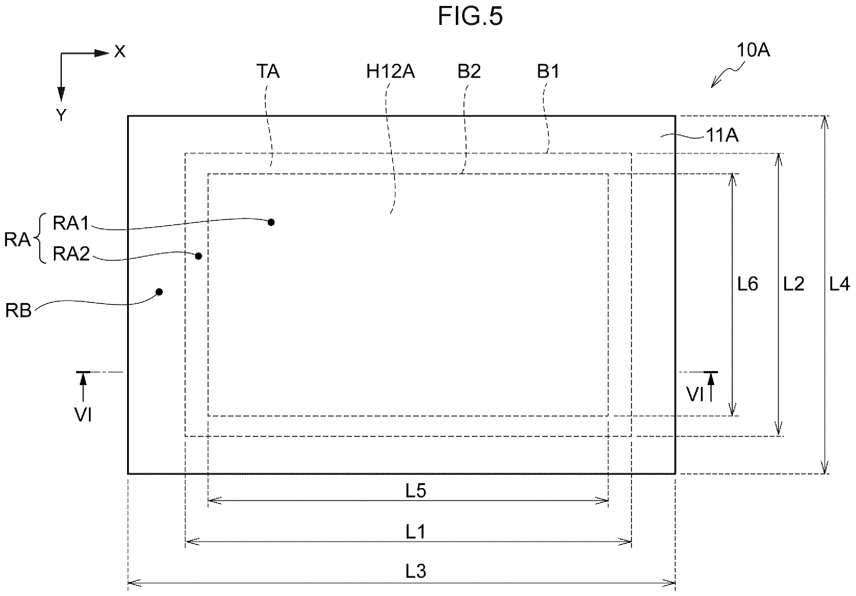

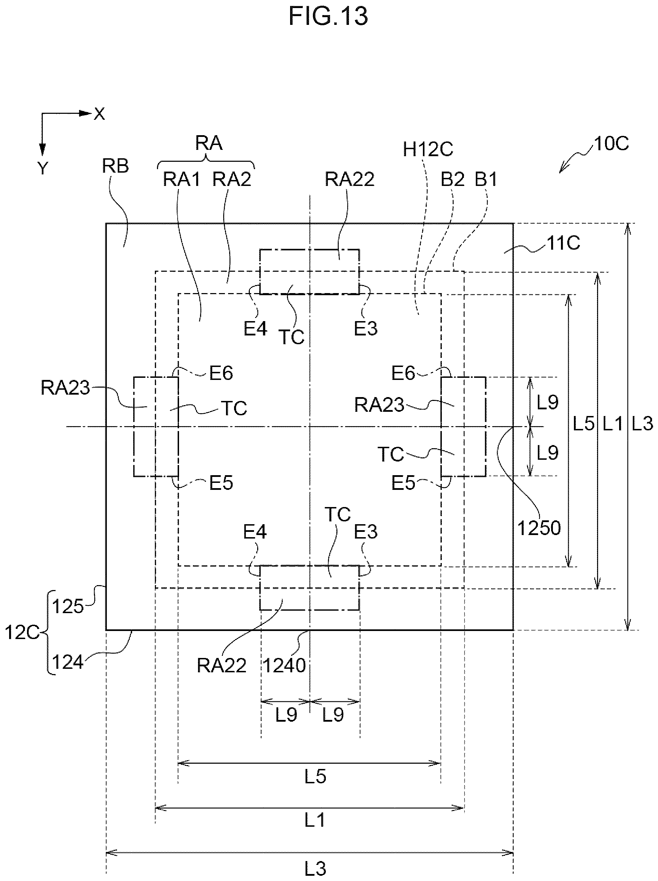

Each pellicle according to a first embodiment and a second embodiment, as one example of the pellicle satisfying (i), will be described below with reference to FIG. 5 to FIG. 10, and FIG. 12. A third embodiment, as one example of the pellicle satisfying (ii), will be described below with reference to FIG. 13.

The pellicle of the disclosure preferably satisfies (i). Thus, not only the film thickness of the exposure region is decreased to increase the transmittance of exposure light, but also breakage of the pellicle film due to the pressure difference inside and outside of the pellicle can be suppressed.

The pellicle of the disclosure preferably satisfies (ii). Thus, not only the film thickness of the exposure region is decreased to increase the transmittance of exposure light, but also breakage of the pellicle film due to the pressure difference inside and outside of the pellicle can be suppressed.

In the pellicle of the disclosure, the film thickness of the thick film portion is not particularly limited, and is preferably from 1.5 times to 100 times the film thickness of the exposing region. Thus, not only breakage of the pellicle film due to the pressure difference inside and outside of the pellicle can be more suppressed, but also production cost is excellent.

It is preferable in the pellicle of the disclosure that the pellicle film includes a carbon nanotube. Thus, the pellicle film can be a thin film excellent in mechanical strength. Therefore, the transmittance of exposure light of the pellicle film can be higher.

It is preferable in the pellicle of the disclosure that the support frame is in contact with the pellicle film. Thus, no adhesive is present between the pellicle film and the support frame. Outgas generally encompasses gas derived from water and gas derived from a component contained in a pressure-sensitive adhesive. Therefore, the amount of generation of outgas can be suppressed.

It is preferable in the pellicle of the disclosure that the pellicle film contains a first film portion having no through-hole, and a second film portion having no film portion in a region corresponding to the exposing region, the first film portion contains a first CNT layer containing a carbon nanotube, the second film portion contains a second CNT layer containing a carbon nanotube, and a total thickness of the first CNT layer and the second CNT layer in the thick film portion is from 1.5 times to 100 times a thickness of the first CNT layer in the exposing region. Thus, breakage of the pellicle film due to the pressure difference inside and outside of the pellicle can be more suppressed.

It is preferable in the pellicle of the disclosure that the second film portion is layered on a surface of the first film portion, the surface being in a region corresponding to the thick film portion of the first film portion and being at an opposite side of the first film portion from the support frame. Thus, even in a case in which a portion of the pellicle film is separated in an end portion of the second film portion and debris of a carbon nanotube is generated, the debris can be inhibited from falling into an exposure original plate in the pellicle.

The exposure original plate of the disclosure includes an original plate, and the pellicle of the disclosure, mounted on the original plate.

Each exposure original plate according to the first embodiment to the third embodiment, as one example of the exposure original plate of the disclosure, will be described below.

The exposure device of the disclosure includes a light source that emits exposure light, the exposure original plate of the disclosure, and an optical system that guides the exposure light emitted from the light source, to the exposure original plate. The exposure original plate is placed so that the exposure light emitted from the light source penetrates the pellicle film and the original plate is irradiated with the exposure light.

Each exposure original plate according to the first embodiment to the third embodiment, as one example of the exposure device of the disclosure, will be described below.

It is preferable in the exposure device of the disclosure that the exposure light is EUV light.

A method of producing a pellicle of a first aspect of the disclosure is a method of producing the pellicle of the disclosure, including a step of preparing the support frame, a step of preparing the pellicle film, and a connection step of connecting the support frame to the pellicle film. Thus, the pellicle of the disclosure is obtained.

A second production method, a fourth production method, and a sixth production method which are each one example of the method of producing the pellicle of the first aspect of the disclosure will be described below.

It is preferable in the method of producing the pellicle of the disclosure that the pellicle film contains a carbon nanotube and the thick film portion is formed by a spray coating method or an ink-jet method in the step of preparing the pellicle film. Thus, a reduction in production cost and selective thickening of only a region of the thick film portion can be made, and the pellicle can be easily produced on a large scale.

A method of producing a pellicle of a second aspect of the disclosure is a method of producing the pellicle of the disclosure, including a step of preparing the support frame, a step of preparing a first film, a step of preparing a second film, a connection step of connecting the support frame to a portion of one main surface of the first film, and a layering step of layering the second film on another main surface of the first film, to form the pellicle film. Thus, the pellicle of the disclosure is obtained.

A first production method, a third production method, and a fifth production method which are each one example of the method of producing the pellicle of the second aspect of the disclosure will be described below.

Each of the first film and the second film preferably includes a carbon nanotube in the method of producing the pellicle of the disclosure. Thus, the resulting pellicle film is favorable in mechanical strength.

It is preferable in the method of producing the pellicle of the disclosure that the pellicle film includes a layered film in which two or more CNT films each including a carbon nanotube are layered. Thus, the resulting pellicle film is more favorable in mechanical strength.

The method of producing a semiconductor device of the disclosure includes a step of allowing exposure light emitted from a light source to penetrate the pellicle film of the exposure original plate of the disclosure, to irradiate the original plate with the exposure light and reflect the exposure light by the original plate, and a step of allowing the exposure light reflected by the original plate to penetrate the pellicle film, to irradiate a sensitive substrate with the exposure light, thereby exposing the sensitive substrate in a pattern shape. Thus, a semiconductor device is obtained.

Each method of producing a semiconductor device according to the first embodiment to the third embodiment, as one example of the method of producing a semiconductor device of the disclosure, will be described below.

### (1) First Embodiment

### (1.1) Pellicle

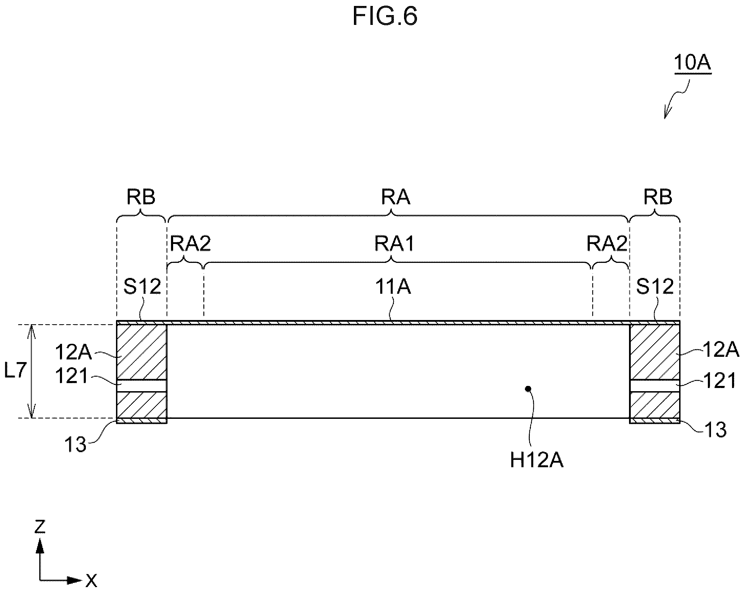

Hereinafter, a pellicle 10A according to the first embodiment of the disclosure will be described with reference to FIG. 5 to FIG. 9B. The pellicle 10A satisfies (i). Particularly, a support frame 12A is a rectangular frame, and a thick film portion TA is located in the whore area of a peripheral border region RA2 in the pellicle 10A. FIG. 5 is a top view illustrating an appearance of the pellicle 10A according to the first embodiment of the disclosure. FIG. 6 is a cross-sectional view on a VI-VI-line of FIG. 5.

The description with the same reference symbol is not repeated with respect to any identical or corresponding part in the drawings.

The pellicle 10A includes, as illustrated in FIG. 5 and FIG. 6, a pellicle film 11A and a support frame 12A (see FIG. 6). The support frame 12A has an opening H12A (see FIG. 6). The pellicle film 11A is supported by the support frame 12A. The pellicle film 11A is in contact with the support frame 12A.

The profile of the opening H12A of the support frame 12Ain a planar view is an oblong in the first embodiment of the disclosure, as illustrated in FIG. 5. The "planar view" means viewing from a surface of the pellicle film 11A, on which no support frame 12A is placed, toward a surface of the pellicle film 11A, on which the support frame 12A is placed, in the thickness direction of the pellicle film 11A.

The profile of the opening H12A of the support frame 12A in a planar view is not particularly limited, and may be a square.

"The pellicle film is in contact with the support frame" means a configuration in which the pellicle film is put to the support frame with no resin adhesive layer being interposed, and a layer (for example, a coating) for binding the pellicle film to the support frame may be interposed between the pellicle film and the support frame.

The material of the coating is not restricted, may be, for example, an inorganic material, a metal-based material, or a semiconductor-based material, and may include Be, Ru, Ge, Pd, Si, Nb, Zr, and/or Mo.

Hereinafter, a direction in which one side of the profile of the oblong opening H12A extends is defined as a left-right direction, in a planar view. A direction perpendicular to the left-right direction in a planar view is defined as a front-back direction. The thickness direction of the support frame 12A is defined as an up-down direction. A surface of the pellicle film 11A, on which the support frame 12A is placed, is defined as a downside and an opposite face thereof is defined as an upside, in the up-down direction.

In FIG. 5 to FIG. 7, a rightside, a leftside, a front side, a backside, an upside, and a downside respectively correspond to an X-axis positive direction, an X-axis negative direction, a Y-axis positive direction, a Y-axis negative direction, a Z-axis positive direction, and a Z-axis negative direction.

### (1.1.1) Pellicle Film

### (1.1.1.1) Self-Supporting Film Region and Supported Region

The pellicle film 11A has a self-supporting film region RA and a supported region RB in a planar view, as illustrated in FIG. 5. The supported region RB surrounds the self-supporting film region RA in a planar view. The self-supporting film region RA is adjacent to the supported region RB.

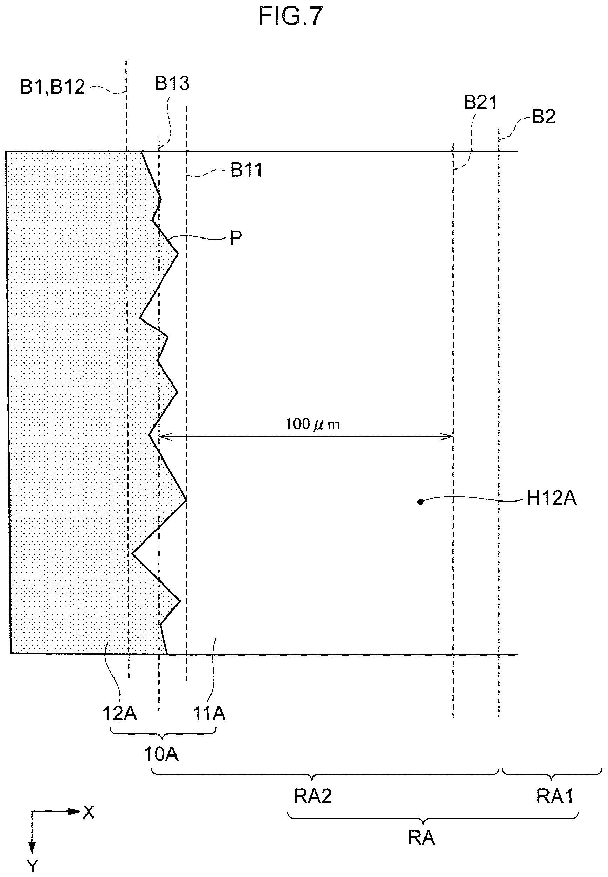

The self-supporting film region RA indicates a region covering the opening H12A of the support frame 12A. Particularly, the self-supporting film region RA indicates a region inside of a first frame border B1 in a planar view. The "first frame border B1" indicates a line along the profile of the opening H12A of the support frame 12A, in a planar view. The detail of the first frame border B1 will be described with reference to FIG. 7. The support frame 12A has a support surface S12 for supporting the pellicle film 11A, as illustrated in FIG. 6. The self-supporting film region RA does not face the support surface S12 of the support frame 12A.

The supported region RB indicates a region of the pellicle film 11A, in which the region does not cover the opening H 12A of the support frame 12A. Particularly, the supported region RB indicates a region outside of the first frame border B1 in a planar view. The supported region RB includes the first frame border B1 (see FIG. 5). The supported region RB faces the support surface S12 of the support frame 12A, as illustrated in FIG. 6.

The size of the self-supporting film region RA is, if appropriate, selected depending on the size or the like of a pattern formed on an original plate. A length L1 (see FIG. 5) of the self-supporting film region RAin the left-right direction (X-axis direction) can be, for example, from 130 mm to 160 mm, and is preferably from 135 mm to 147 mm, more preferably from 137 mm to 145 mm. A length L2 (see FIG. 5) of the self-supporting film region RAin the up-down direction (Z-axis direction) can be, for example, from 100 mm to 125 mm, and is preferably from 110 mm to 116 mm, more preferably from 107 mm to 113 mm.

A length L3 (see FIG. 5) of the supported region RB in the left-right direction (X-axis direction) may be a length that is more than the length L1 of the self-supporting film region RA in the left-right direction (X-axis direction) and that can allow the pellicle film 11A to be supported by the support frame 12A. The length L3 of the supported region RB in the left-right direction (X-axis direction) is, for example, from 131 mm to 166 mm, preferably from 136 mm to 153 mm, more preferably from 138 mm to 152 mm. A length L4 (see FIG. 5) of the supported region RB in the up-down direction (Z-axis direction) may be a length that is more than the length L2 of the self-supporting film region RA in the up-down direction (Z-axis direction) and that can allow the pellicle film 11A to be supported by the support frame 12A.

The self-supporting film region RA contains an exposing region RA1 and a peripheral border region RA2 in a planar view, as illustrated in FIG. 5. The peripheral border region RA2 surrounds the exposing region RA1. The exposing region RA1 is adjacent to the peripheral border region RA2, in the first embodiment of the disclosure.

The exposing region RA1 indicates a region allowing for penetration of EUV light in EUV exposure. The exposing region RA1 indicates a region inside of a second frame border B2 (see FIG. 5). The second frame border B2 will be described with reference to FIG. 7. The "region allowing for penetration of EUV light" indicates an EUV light irradiation area necessary for exposure of a desired pattern shape on a sensitive substrate described below. The EUV light irradiation area indicates a zone of the self-supporting film region RA, in which the zone is designed in advance before EUV exposure.

The peripheral border region RA2 indicates a region outside of the second frame border B2. The peripheral border region RA2 may also be a region not allowing for penetration of EUV light in EUV exposure. The peripheral border region RA2 includes the second frame border B2. The "region not allowing for penetration of EUV light" indicates a zone of the self-supporting film region RA, in which the zone is out of the EUV light irradiation area. EUV light scattered by an original plate or the like described below may penetrate the region not allowing for penetration of EUV light.

The first frame border B1 and the second frame border B2 will be described with reference to FIG. 7. FIG. 7 is a schematic top view of a microscope image obtained by imaging a portion of a peripheral border of the opening H12A, from above the pellicle film 11A of the pellicle 10A according to the first embodiment of the disclosure. Particularly, FIG. 7 illustrates a schematic top view of a microscope image of a left portion of the peripheral border of the opening H12A.

The first frame border B1 and the second frame border B2 are determined by the following method.

First, one side of four sides of the peripheral border of the oblong opening H12A is imaged from above the pellicle film 11A of the pellicle 10A in a planar view. As illustrated in FIG. 7, a profile line P of the peripheral border of the opening H12Ais extracted in the resulting microscope image of the pellicle 10A.

In a case in which the profile line P of the opening H12A is clear, the profile line P usually has a depressed and protruded shape or a straight line shape. A straight line B11 (hereinafter, also referred to as "edge portion profile line B11") in parallel with the front-back direction (Y-axis direction) is drawn so as to be contacted with a portion of the profile line P of the opening H12A, in which the portion is most protruded toward the opening H12A (namely, protruded portion).

Aline B12 (hereinafter, also referred to as "edge portion profile line B12") in parallel with the edge portion profile line B11 is drawn so as to be contacted with a portion of the profile line P of the opening H12A in the microscope image of the pellicle 10A, in which the portion is most depressed opposite to the opening H12A (namely, depressed portion). The first frame border B1 is oblong in a planar view, as in the profile of the opening H12A. The edge portion profile line B12 forms one side of the first frame border B 1.

A straight line B13 (hereinafter, also referred to as "average edge portion profile line B13") is drawn at a position between the resulting edge portion profile line B11 and edge portion profile line B12, in the left-right direction (X-axis direction). The average edge portion profile line B 13 is in parallel with each of the edge portion profile line B11 and the edge portion profile line B12.

A straight line B21 (hereinafter, also referred to as "reference line B21") passing through a position apart by 100 µm from the average edge portion profile line B13 in a direction (right direction (X-axis positive direction)) of the exposing region RA1 is drawn. The reference line B21 is in parallel with the average edge portion profile line B13. The second frame border B2 is located closer to the exposing region RA1 relative to the reference line B21. In other words, the second frame border B2 is apart by more than 100 µm from the average edge portion profile line B13 toward the exposing region RA1. The second frame border B2 in parallel with the reference line B21. The second frame border B2 is oblong in a planar view, as in the profile of the opening H12A.

One side of each of the first frame border B1 and the second frame border B2 is thus determined. The remaining three sides of each of the first frame border B1 and the second frame border B2 are also similarly determined.

The first frame border B1 and the second frame border B2 are determined as above.

The method of imaging the peripheral border portion of the opening H12A from above the pellicle film 11A with a microscope is preferably made with a laser microscope or an optical microscope. The observation magnification is not particularly limited, and is preferably in a range of from 200x to 1000x.

Specifically, a shape analysis laser microscope (for example, VK-100 of VK series) manufactured by KEYENCE CORPORATION is used and the magnification of an objective lens is 20x, and the support frame 12A is placed on a stage so that a contact surface thereof with the pellicle film 11A is perpendicular to incident light.

A section observed includes an edge portion located inside of the support frame 12A (namely, closer to a center portion of the pellicle 10A illustrated in FIG. 5).

In a case in which the profile line P of the opening H12A is unclear in the microscope image of the pellicle 10A, an image of a height profile of the support frame 12A is displayed and a level line of a portion located below by about 10 µm from a contact surface (uppermost portion) of the support frame 12A with the pellicle film is adopted as the profile line, to determine the edge portion profile line B11 and the edge portion profile line B12 and define a center line between the edge portion profile line B11 and the edge portion profile line B12 as the average edge portion profile line B13. The contact surface (uppermost portion) of the support frame 12A with the pellicle film means the support surface S12.

The self-supporting film region RA may contain an intermediate region. The intermediate region may be a region not allowing for penetration of EUV light in EUV exposure. The intermediate region is located between the exposing region RA1 and the peripheral border region RA2 in a planar view. Particularly, the intermediate region surrounds the exposing region RA1. The intermediate region is surrounded by the peripheral border region RA2. The intermediate region is adjacent to each of the exposing region RA1 and the peripheral border region RA2. The configuration of the intermediate region may be the same as the configuration of the exposing region RA1, or may be the same as the configuration of the peripheral border region RA2.

A length L5 (see FIG. 5) of the exposing region RA1 in the left-right direction (X-axis direction) is preferably from 133 mm to 145 mm, more preferably from 135 mm to 143 mm. A length L6 (see FIG. 5) of the exposing region RA1 in the front-back direction (Y-axis direction) is preferably from 105 mm to 115 mm, more preferably from 106 mm to 113 mm.

### (1.1.1.2) Film Thickness of Pellicle Film

The film thickness of the peripheral border region RA2 is thicker than the film thickness of the exposing region RA1 in the pellicle film 11A. In other words, the thick film portion TA is located in the whore area of the peripheral border region RA2 of the pellicle film 11A. Thus, mechanical strength of the peripheral border region RA2 is higher than mechanical strength of the exposing region RA1. As a result, the pellicle film 11A can be suppressed in breakage of the pellicle film 11A due to the pressure difference inside and outside of the pellicle 10A, as compared with a configuration in which the film thickness of the peripheral border region RA2 and the film thickness of the exposing region RA1 are the same. The thick film portion TA is provided so as to step across the first frame border B1 in a direction from the peripheral border region RA2 toward the supported region RB, whereby breakage of the pellicle film 11A due to stress concentration to the pellicle film on the edge portion of a pellicle frame 12A can be suppressed.

The ratio of the film thickness of the peripheral border region RA2 (namely, the film thickness of the thick film portion TA) to the film thickness of the exposing region RA1 is preferably from 1.5 times to 100 times. Thus, not only the film thickness of the exposing region RA1 of the pellicle film 11A is decreased to increase the transmittance of exposure light, but also breakage of the pellicle film 11A due to the pressure difference inside and outside of the pellicle 10A can be suppressed and also production cost is excellent.

The lower limit of the ratio of the film thickness of the peripheral border region RA2 to the film thickness of the exposing region RA1 is more preferably 1.9 times or more, still more preferably 5 times or more, particularly preferably 10 times or more from the viewpoint of further suppression of breakage of the pellicle film 11A due to the pressure difference inside and outside of the pellicle 10A.

The upper limit of the ratio of the film thickness of the peripheral border region RA2 to the film thickness of the exposing region RA1 is preferably 70 times or less, more preferably 50 times or less from the viewpoint of production cost.

The film thickness of the exposing region RA1 may be, if appropriate, selected depending on the material or the like of the pellicle film 11A, and is preferably from 2 nm to 40 nm. Thus, not only degradation due to damage of the pellicle film 11A can be suppressed, but also the transmittance of EUV light can be increased.

The lower limit of the film thickness of the exposing region RA1 is more preferably 6 nm or more, still more preferably 8 nm or more, particularly preferably 10 nm or more from the viewpoint of more suppression of degradation due to damage of the pellicle film 11A.

The upper limit of the film thickness of the exposing region RA1 is more preferably 30 nm or less, still more preferably 20 nm or less, particularly preferably 10 nm or less from the viewpoint of a more increase in transmittance of EUV light. As the film thickness of the exposing region RA1 is thinner, the problems of the first embodiment of the disclosure are made apparent.

The film thickness of the peripheral border region RA2 (namely, the film thickness of the thick film portion TA) may be, if appropriate, selected depending on the film thickness or the like of the exposing region RA1, and is preferably from 5 nm to 500 nm. Thus, not only production cost can be reduced, but also breakage of the pellicle film 11A can be suppressed.

The upper limit of the film thickness of the peripheral border region RA2 is more preferably 100 nm or less, still more preferably 50 nm or less from the viewpoint of a more reduction in production cost.

The lower limit of the film thickness of the peripheral border region RA2 is more preferably 10 nm or more, still more preferably 20 nm or more from the viewpoint of more suppression of breakage of the pellicle film 11A.

The film thickness of the supported region RB is not particularly limited, and may be the same as or different from the film thickness of the peripheral border region RA2. In particular, the film thickness of the supported region RB is more preferably the same as the film thickness of the peripheral border region RA2 from the viewpoint of, for example, ease of production.

### (1.1.1.2.1) Method of Measuring Film Thickness

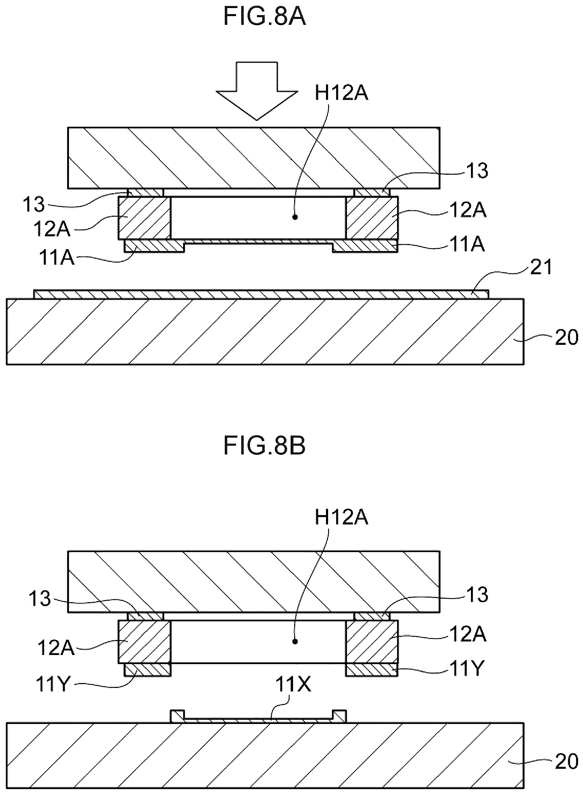

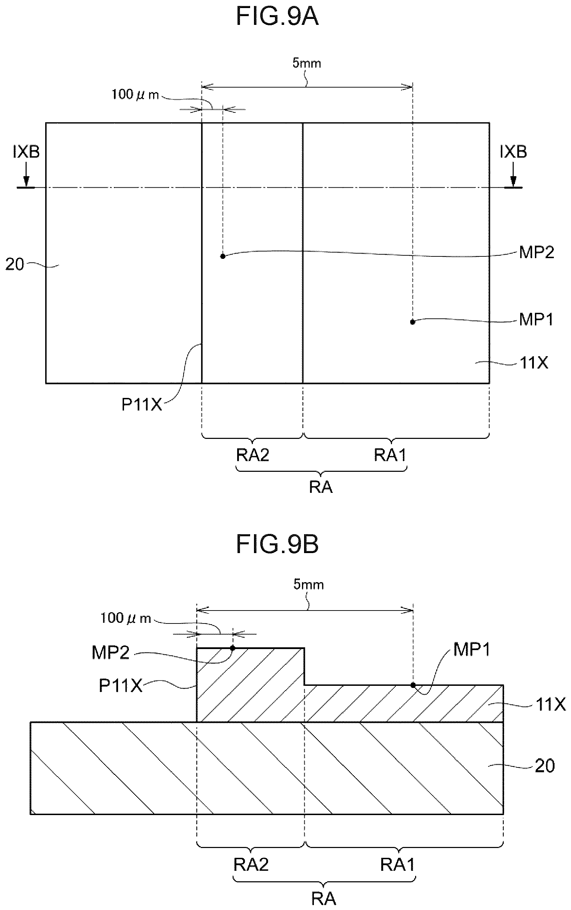

The method of measuring each of the film thickness of the exposing region RA1 and the film thickness of the peripheral border region RA2 (namely, the film thickness of the thick film portion TA) will be described with reference to FIG. 8A to FIG. 9B. FIG. 8A and FIG. 8B are each an illustration diagram for describing a method of transferring the self-supporting film region RA of the pellicle film 11A according to the first embodiment of the disclosure, onto a silicon substrate 20. FIG. 9A is a top view of a silicon substrate onto which a site 11X corresponding to the self-supporting film region of the pellicle film 11A according to the first embodiment of the disclosure is transferred. FIG. 9B is a cross-sectional view on an IXB-IXB line of FIG. 9A.

The film thickness of the exposing region RA1 and the film thickness of the peripheral border region RA2 are each obtained by transferring only the site 11X (hereinafter, also referred to as "self-supporting film portion 11X") corresponding to the self-supporting film region RA of the pellicle film 11A, onto the silicon substrate 20, and measuring the film thickness of a specified site of the self-supporting film portion 11X with a film thickness measurement apparatus.

Specifically, first, a solvent is dropped on the silicon substrate 20, to form a solvent layer 21 on the silicon substrate 20, as illustrated in FIG. 8A. Next, the pellicle film 11A of the pellicle 10Ais allowed to face the silicon substrate 20, and the pellicle 10Ais loaded on the silicon substrate 20. The solvent layer 21 is interposed between the silicon substrate 20 and the pellicle film 11A.

The silicon substrate 20 may be larger in size than the self-supporting film region of the pellicle film 11A, and a silicon wafer of a size of 4 inches or more is preferably used.

Examples of the solvent include water and an organic solvent.

Next, the solvent layer 21 is dried, thereby allowing the pellicle film 11A to tightly contact with the silicon substrate 20 without any gap. Next, the silicon substrate 20 is secured and the support frame 12A of the pellicle 10A is lifted up, whereby the site 11X corresponding to the self-supporting film region RA of the pellicle film 11A is separated from the pellicle film 11A and remains on the silicon substrate 20, as illustrated in FIG. 8B. In other words, the self-supporting film portion 11X is transferred onto the silicon substrate 20. The profile of the self-supporting film portion 11X is along the profile of the opening H12A of the support frame 12A in a planar view. A site 11Y corresponding to the supported region RB of the pellicle film 11A is still attached to the support frame 12A.

Next, the film thickness of a specified measurement site of the self-supporting film portion 11X, transferred onto the silicon substrate 20, is measured with a microspectroscopy film thickness meter (for example, OPTM, Model: A-1, manufactured by Otsuka Electronics Co., Ltd.) as the film thickness measurement apparatus.

The lens, and the apparatus for adjustment of the diameter of a measurement point, here used, are, for example, respectively a reflection type 10x lens and an aperture having a diameter of 200 µm (diameter of measurement point: 20 µm).

An aluminum substrate is used as a reference for reflection intensity measurement.

### (1.1.1.2.2) Measurement Point

In the first embodiment of the disclosure, the measurement value of the film thickness at a measurement point MP1 of the self-supporting film portion 11X is defined as the film thickness of the exposing region RA1. The measurement point MP1 indicates a position apart by 5 mm from an edge P11X of the self-supporting film portion 11X toward the exposing region RA1, as illustrated in FIG. 9A.

In the first embodiment of the disclosure, the measurement value of the film thickness at a measurement point MP2 of the self-supporting film portion 11X is defined as the film thickness of the peripheral border region RA2. The measurement point MP2 is a position apart by 100 µm from the edge P11X of the self-supporting film portion 11X and from the edge P11X of the self-supporting film portion 11X toward the exposing region RA1, as illustrated in FIG. 9A.

### (1.1.1.2.3) Conversion Method into Film Thickness (Optical Thickness)

A reflective index spectrum in a wavelength range of from 200 nm to 600 nm is acquired in a wavelength interval range of from 1 nm to 2 nm, with respect to each of the measurement points.

In a case in which the pellicle film 11A is a film containing a carbon nanotube (hereinafter, also referred to as "CNT film"), the film thickness at each of the measurement points can be calculated by analyzing a reflective index spectrum in a wavelength range of from 225 to 500 nm according to a least-square method with a three-layer model of air layer/CNT film layer/silicon substrate.

An optical constant depending on the material of the pellicle film 11A can be used as the optical constant of a layer of the pellicle film 11A. The optical constant of graphite can be used in a case in which the pellicle film 11A is formed from graphite, and the value of an optical constant (refractive index: n, extinction coefficient: k) shown in Table 1 can be used in a case in which the pellicle film 11A is formed from a CNT film.

**[Table 1]**

| [nm] | n | k |
|---|---|---|
| 225 | 1.20 | 0.61 |
| 248 | 1.34 | 0.75 |
| 276 | 1.52 | 0.76 |
| 310 | 1.64 | 0.72 |
| 354 | 1.71 | 0.68 |
| 413 | 1.75 | 0.68 |
| 496 | 1.81 | 0.70 |

The optical constant of the CNT film is sometimes different from such an optical constant shown in Table 1, depending on the type of CNT. In a case in which the optical constant of the CNT film is different from such an optical constant shown in Table 1, the method of measuring the film thickness of the CNT film may be a measurement method with a contact type film thickness meter (hereinafter, simply referred to as "contact type measurement method"). The contact type film thickness meter here used can be a stylus thickness measurement apparatus (DEKTAK) or the like.

### (1.1.1.2.4) Contact Type Measurement Method

In a case in which the method of measuring the film thickness of the pellicle film 11A is the contact type measurement method, the film thickness of the pellicle film 11A can be measured as follows.

The pellicle film 11A is transferred onto the silicon substrate 20 in the same manner as in [method of measuring each of film thickness of exposing region and film thickness of peripheral border region] described above.

A portion of the self-supporting film portion 11X is removed at a position apart by 5 mm from the edge P11X of the self-supporting film portion 11X toward the exposing region RA1 (position in the exposing region RA1). Thus, a surface of the silicon substrate 20 is unshrouded. The substrate surface height and the first film surface height are each measured with the contact type film thickness meter. The "substrate surface height" means the thickness of only the silicon substrate 20. The "first film surface height" means the total thickness of the silicon substrate 20 and the exposing region RA1 of the self-supporting film portion 11X. The thickness in the exposing region RA1 of the self-supporting film portion 11X, namely, the film thickness in the exposing region RA1 of the pellicle film 11A is obtained from the difference between the substrate surface height and the first film surface height.

A portion of the self-supporting film portion 11X is removed at a position apart by 100 µm from the edge P11X of the self-supporting film portion 11X and from the edge P11X of the self-supporting film portion 11X toward the exposing region RA1 (position in the peripheral border region RA2). Thus, a surface of the silicon substrate 20 is unshrouded. The substrate surface height and the second film surface height are each measured with the contact type film thickness meter. The "second film surface height" means the total thickness of the silicon substrate 20 and the peripheral border region RA2 of the self-supporting film portion 11X. The film thickness of the peripheral border region RA2 of the self-supporting film portion 11X, namely, the film thickness of the peripheral border region RA2 of the pellicle film 11A is obtained from the difference between the substrate surface height and the second film surface height.

In a case in which the optical constant of the CNT film is an optical constant shown in Table 1 and the film thickness of the self-supporting film region RA is 50 nm or less, the method of measuring the film thickness of the pellicle film 11A (CNT film) may be the contact type measurement method. In particular, in a case in which the film thickness of the self-supporting film region RA of the pellicle film 11A (CNT film) is 100 nm or more, the measurement error may be increased in the case of use of the microspectroscopy film thickness meter as the film thickness measurement apparatus. Therefore, in a case in which the film thickness of the self-supporting film region RA of the pellicle film 11A (CNT film) is 100 nm or more, the contact type measurement method is preferable.

In a case in which the pellicle film 11A is not the CNT film, the method of measuring the film thickness of the pellicle film 11A may be the contact type measurement method.

### (1.1.1.3) Structure of Pellicle Film

The structure of the pellicle film 11A is not particularly limited, and may be a single-layer structure or a layered structure. In particular, the structure of the pellicle film 11A is preferably a layered structure from the viewpoint of, for example, ease of production of the pellicle film 11A. The layered structure is, for example, a layered body of a first film portion (hereinafter, also referred to as "unprocessed film") and a second film portion (hereinafter, "first processed film"). The unprocessed film is a flat film having no through-hole. The first processed film is a flat film having a through-hole. The through-hole passes through a region corresponding to the exposing region. The peripheral border of the through-hole of the first processed film corresponds to the second frame border B2. In other words, the first processed film has no film portion in the region corresponding to the exposing region RA1. The unprocessed film and the first processed film each may be a single-layer film or may be a layered film in which a plurality of single-layer films is layered. The respective materials in the plurality of single-layer films may be the same as or different from each other.

The first processed film may be located on a surface of the pellicle film 11A, in which the surface faces the support frame 12A, or may be located on a surface of the pellicle film 11A, in which the surface is opposite to the support frame 12A. In particular, the first processed film is preferably layered on a surface of the unprocessed film, in which the surface faces the support frame 12A, from the viewpoint of, for example, preventing foreign substances from entering the opening H12A through an inner peripheral wall of the through-hole of the first processed film. That is, the first processed film is preferably located on a surface of the pellicle film 11A, in which the surface is opposite to the support frame 12A. In other words, the support frame 12A, the unprocessed film, and the first processed film are preferably placed in the listed order in the upper direction (Z-axis positive direction) from the lower direction (Z-axis negative direction). Such foreign substances entering through the inner peripheral wall of the through-hole of the first processed film include fibers waste of the first processed film.

### (1.1.1.4) Material of Pellicle Film

The material of the pellicle film 11A is not particularly limited, and examples thereof include a carbonaceous material, SiN, and polysilicon. The carbonaceous material includes a carbon nanotube.

In a case in which the pellicle film 11A has a layered structure, the material of the unprocessed film and the material of the first processed film may be the same as or different from each other.

While the pellicle film 11A is in direct contact with the support frame 12A in the first embodiment of the disclosure, the pellicle film 11A may be supported by the support frame 12A with an adhesive layer for a film being interposed. In a case in which the pellicle film 11A is supported by the support frame 12A with an adhesive layer for a film being interposed, the pellicle film 11A may include the unprocessed film and an adhesive film. The adhesive film includes an adhesive leaked out the unprocessed film, in which the adhesive constitutes the adhesive layer for a film. The adhesive layer is formed in a region corresponding to the peripheral border region RA2 on the unprocessed film. Examples of the adhesive constituting the adhesive layer for a film include the same as those exemplified for an adhesive constituting an adhesive layer for an original plate, described below.

In particular, the material of the pellicle film 11A preferably includes a carbon nanotube. The pellicle film 11A is the CNT film, whereby favorable mechanical strength can be obtained.

### (1.1.1.4.1) CNT Film

The size of CNT can be, for example, from 0.8 nm to 400 nm.

The tube size is preferably 2 nm or more, more preferably 4 nm or more, still more preferably 8 nm or more, very preferably 10 nm or more, particularly preferably 20 nm or more from the viewpoint of suppression of breakage of the pellicle film 11A.

The tube size is preferably 100 nm or less, more preferably 80 nm or less, still more preferably 60 nm or less, particularly preferably 40 nm or less from the viewpoint of an enhancement in optical transmittance.

The size of CNT refers to the size of a single fiber in the case of the presence as the single fiber in the pellicle film 11A, and refers to the size of a CNT bundle (namely, bundle) in the case of the presence as the bundle in the pellicle film.

CNT is not particularly restricted, and may be a single wall CNT or a multi-wall CNT.

In a case in which CNT is a single wall CNT, the thickness of a bundle of the single wall CNT may be, for example, from 4 nm to 400 nm.

The thickness of the bundle is preferably 10 nm or more, more preferably 20 nm or more, still more preferably 40 nm or more, particularly preferably 50 nm or more from the viewpoint of suppression of breakage of the pellicle film 11A.

The thickness of the bundle is preferably 100 nm or less, more preferably 80 nm or less, still more preferably 60 nm or less, particularly preferably 40 nm or less from the viewpoint of an enhancement in optical transmittance.

In a case in which CNT is a multi-wall CNT, the thickness of a single fiber of the multi-wall CNT may be, for example, from 4 nm to 400 nm.

The thickness of the bundle is preferably 10 nm or more, more preferably 20 nm or more, still more preferably 40 nm or more, particularly preferably 50 nm or more from the viewpoint of suppression of breakage of the pellicle film 11A.

The thickness of the single fiber of the multi-wall CNT is preferably 100 nm or less, more preferably 80 nm or less, still more preferably 60 nm or less, particularly preferably 40 nm or less from the viewpoint of an enhancement in optical transmittance.

CNT in the pellicle film 11A preferably forms a non-woven shape.

The shape of CNT included in the pellicle film 11A is usually a fiber shape, whereby the pellicle film 11A as a whole can form a non-woven shape.

CNT included in the pellicle film 11A forms a non-woven shape, whereby the pellicle film 11A can ensure air permeability.

For example, in a case in which exposure is performed with EUV light by an exposure device including the pellicle 10A, the pellicle 10A is demanded to be irradiated with EUV light under vacuum or reduced pressure conditions.

The pellicle 10A has a vent hole 121, as illustrated in FIG. 6. The vent hole 121 is formed in the support frame 12A. A vacuum or reduced pressure environment is made by removing air inside the pellicle 10A through the vent hole 121. However, a problem has been that a lot of troubles are taken for forming the vent hole 121 in the support frame 12A.

CNT in the pellicle film 11A forms a non-woven shape, whereby such a non-woven shape can allow air permeability to be ensured and allow a vacuum or reduced pressure environment to be easily made.

### (1.1.1.4.2) Antioxidant Layer

Other layer may be layered on the pellicle film 11A.

An antioxidant layer may be layered on at least one surface of the pellicle film 11A.

The pellicle 10A can further include an antioxidant layer, thereby allowing oxidation of the pellicle film 11A to be suppressed during light irradiation or pellicle storage.

The material of the antioxidant layer is not particularly limited as long as the material is a material stable against EUV light. For example, the material of the antioxidant layer can be SiOₓ (x ≤ 2), SiₓN_{y} (x/y is 0.7 to 1.5), SiON, Y₂O₃, YN, Mo, Ru, Rb, Sr, Y, Zr, Nb, or Rh.

The thickness of the antioxidant layer is preferably from about 1 nm to 10 nm, more preferably from about 2 nm to 5 nm in order not to inhibit penetration of EUV light. The thickness of the antioxidant layer is from about 1 nm to 10 nm, whereby the antioxidant layer can be inhibited from absorbing EUV light and a reduction in transmittance of EUV light of the pellicle film 11A can be suppressed.

The proportion of the thickness of the antioxidant layer with respect to the thickness of the pellicle film 11A is preferably in a range of from 0.03 to 1.0. In a case in which the proportion of the thickness of the antioxidant layer with respect to the thickness of the pellicle film 11A is in the numerical value range, the antioxidant layer can be inhibited from absorbing light and a reduction in transmittance can be suppressed.

In a case in which the antioxidant layer is layered on the pellicle film 11A, reflection of light occurs at a layer interface newly generated, namely, an interface between the antioxidant layer and air, and an interface between the antioxidant layer and the pellicle film 11A, possibly leading to a reduction in transmittance. The reflective index of light at such a layer interface can be calculated depending on the thicknesses of the pellicle film 11A and the antioxidant layer, and the type of each element constituting the pellicle film 11A and the antioxidant layer. The reflective index can be reduced by optimizing the thicknesses of the films as in the principle of a reflection prevention film.

The thickness of the antioxidant layer is preferably an optimal thickness as long as not only a reduction in optical transmittance due to absorption and a reduction in optical transmittance due to reflection are suppressed, but also oxidation prevention performance is possessed.

The thickness uniformity and the surface roughness of the antioxidant layer are also not particularly limited. The antioxidant layer may be either a continuous layer or a sea-island layer as long as transmittance ununiformity derived from film thickness ununiformity or surface roughness, any failure due to light scattering, and the like are not caused in an exposure patterning step, and may be ununiform in film thickness or may have surface roughness.

The average refractive index of a film in which the pellicle film 11A and the antioxidant layer are combined is preferably in a range of from 1.9 to 5.0. The refractive index can be measured according to a procedure such as spectroscopic ellipsometry. The average density of the film in which the pellicle film 11A and the antioxidant layer are combined is preferably in a range of from 1.5g/cm³ to 5.0g/cm³. The density can be measured by a procedure such as an X-ray reflection method.

The tolerable differential pressure in the case of a size of the self-supporting film region RA of 143 mm × 111 mm is, for example, 10 Pa or more, preferably 20 Pa or more, still more preferably 30 Pa or more, more preferably 50 Pa or more.

The method of measuring the tolerable differential pressure in the case of a size of the self-supporting film region RA of 143 mm × 111 mm is the same as in the description "Breaking evaluation by bulge test" in Examples.

In a case in which the pellicle film 11A includes a CNT film and other layer is layered on the CNT film, the film thickness of the CNT film is thicker than the film thickness of such other layer.

In a case in which the pellicle film 11A includes a CNT film and other layer is layered on the CNT film, the outermost layer among layers constituting the pellicle film 11A is preferably such other layer.

In a case in which the pellicle film 11A includes a CNT film and other layer is layered on the CNT film, another aspect is such that the film thickness of the CNT film with respect to the film thickness of the entire pellicle film 11A including such other layer is preferably 50% or more, still more preferably 70% or more.

### (1.1.1.5) Physical Properties of Pellicle Film

In a case in which, for example, EUV is used as light during exposure, the energy of EUV is converted into heat through various relaxation processes. Therefore, the pellicle film 11A preferably has heat dissipation and heat resistance.

The pellicle film 11A includes CNT, whereby the pellicle film 11A can have both heat dissipation and heat resistance and is less possibly broken in EUV lithography.

Accordingly, although a conventional pellicle film 11A including monocrystal silicon has the problems of being low in heat dissipation and being easily deformed or broken by thermal damage in EUV light irradiation, the pellicle film 11A can be used to certainly protect an original plate.

The detail of the reason or the like why the pellicle film 11A including CNT has both heat dissipation and heat resistance has been described in Japanese National-Phase Publication (JP-A) No. 2015/178250.

### (1.1.2) Support Frame

The support frame 12A supports the pellicle film 11A, as illustrated in FIG. 5.

The support frame 12A is a tubular product. The support frame 12A is a frame of a rectangular shape (namely, oblong shape), formed by a pair of longer side portions 122 and a pair of shorter side portions 123, in a planar view. The support frame 12A has the opening H12A. The opening H12A is a through-hole for EUV exposure. EUV light penetrating the exposing region RA1 of the pellicle film 11A in EUV exposure passes through the opening H12A and reaches an original plate.

The size of the opening H12A is substantially the same as the size of the first frame border B1 in a planar view.

A length L7 (see FIG. 6) of the support frame 12A in the up-down direction (Z-axis direction) is, for example, about 2 mm.

The support frame 12A has the vent hole 121 that allows the atmospheric pressures in a space surrounded by the pellicle 10A and an original plate (not illustrated) and the interior of an EUV exposure device to be constant, as illustrated in FIG. 6. The support frame 12A does not necessarily have the vent hole 121. Even in a case in which the support frame 12A does not have the vent hole 121, the pellicle film 11A by itself can have air permeability to create a vacuum environment and a reduced pressure environment, as long as the film has a non-woven shape.

The exposure by EUV light is performed under a vacuum environment (reduced pressure environment). Therefore, the pellicle film 11A may be expanded or contracted by the pressure difference inside and outside of the pellicle during a reduction in pressure to vacuum. The pellicle film 11A is here possibly broken. The vent hole 121 is preferably provided with a filter so that foreign substances do not enter the region surrounded by the pellicle 10A and an original plate.

Examples of the filter include an ULPA (Ultra Low Penetration Air) filter and a metal mesh. The support frame 12A may also be colored so as to facilitate examination as long as no problem is posed for any exposure.

The material, the shape, and the like of the support frame 12A are not particularly limited as long as the pellicle film 11A can be supported.

The material of the support frame 12A may contain, for example, aluminum, titanium, stainless steel, a ceramic-based material (for example, silicon or glass), or a resin such as polyethylene.

In particular, the material of the support frame 12A preferably contains aluminum, titanium, stainless steel, silicon, or glass, more preferably contains aluminum, titanium, or silicon, from the viewpoint that the water content is not high and the amount of outgas generated is suppressed.

The support frame 12A may include a first support frame supporting the pellicle film 11A and a second support frame connected to the first support frame.

In a case in which the support frame 12A includes the first support frame and the second support frame, the first support frame and the second support frame may adhere with an adhesive layer for a support frame. Examples of the adhesive constituting the adhesive layer for a support frame include the same as those exemplified for an adhesive constituting an adhesive layer 13 for an original plate, described below.

For example, the pellicle 10A, which includes a support frame having a configuration for connection of the second support frame to the first support frame, may be produced by a plurality of cooperators including one for production of the first support frame supporting the pellicle film 11A and one for connection of the second support frame to the first support frame, in the disclosure.

The pellicle 10A also encompasses a configuration including the pellicle film 11A and the first support frame at a stage prior to connection to the second support frame.

The procedure or method of securing the pellicle film 11A to such a support frame is not particularly limited. A substrate etched may be used as a portion of the support frame 12A. For example, the pellicle film 11A may be layered on a substrate that can be removed by a specified treatment method, such as a metal, a silicon substrate, glass, a resin, or a salt, and thereafter a mask may be applied to a substrate surface opposite to a surface for placement of the pellicle film 11A so as to be matched with the size of the frame and etching or dissolution may be made with a mask shape remaining. Thus, the pellicle 10A, in which a portion of a substrate is used as the support frame, can be obtained.

The trimming method of matching the shape of the substrate with the shape of the frame is not particularly limited. In a case in which a silicon substrate is used, a method of mechanically splitting a wafer or a laser trimming method can be used.

### (1.1.3) Adhesive Layer

The pellicle 10A according to the first embodiment of the disclosure includes an adhesive layer 13 for an original plate, as illustrated in FIG. 6. The adhesive layer 13 for an original plate contains an adhesive.

The pellicle 10A does not necessarily include the adhesive layer 13 for an original plate.

### (1.1.3.1) Adhesive

The adhesive contained in the adhesive layer 13 for an original plate is not particularly restricted.

Examples of the adhesive include an acrylic resin adhesive, an epoxy resin adhesive, a polyimide resin adhesive, a silicone resin adhesive, an inorganic adhesive, a double-faced pressure-sensitive adhesive tape, a polyolefin-based adhesive, and a hydrogenated styrene-based adhesive.

In particular, the adhesive is preferably at least one selected from the group consisting of a silicone resin adhesive, an acrylic resin adhesive, a hydrogenated styrene-based adhesive, and an epoxy resin adhesive, from the viewpoint of ease of application/processing and ease of curing/processing treatment.

The adhesive in the disclosure conceptually encompasses not only an adhesive, but also a pressure-sensitive adhesive.

In a case in which the adhesive is applied along the entire periphery of the pellicle 10A, the thickness of the adhesive layer 13 for an original plate may be from 1 µm to 1 mm, and is preferably from 5 µm to 500 µm, still more preferably from 10 µm to 200 µm.

### (1.1.4) Use of Pellicle

The pellicle 10A may serve as not only a protection member for inhibiting foreign substances from being attached to an original plate in an EUV exposure device, but also a protection member for protection of an original plate during storage of such an original plate or conveyance of such an original plate. For example, in a case in which the pellicle is in the state of being mounted to an original plate (exposure original plate), the pellicle can be taken out from an EUV exposure device and then, for example, stored as it is. Examples of the method of mounting the pellicle to an original plate include a method of adhering with an adhesive, an electrostatic adsorption method, and a mechanical securing method.

The pellicle 10A is suitably used for exposure with short-wavelength exposure light (for example, EUV light or light further shorter in wavelength than EUV light).

In particular, the pellicle film 11A is suitably used for exposure with EUV light.

In the disclosure, the "EUV (Extreme Ultra Violet) light" refers to light of a wavelength of from 1 nm to 30 nm. The wavelength of EUV light is preferably from 5 nm to 13.5 nm.

In the disclosure, EUV light and light shorter in wavelength than EUV light are also collectively referred to as "EUV light".

### (1.1.5) Variation

The antioxidant layer may be layered on each of both surfaces of the pellicle film 11A forming the pellicle 10A in a variation of the pellicle 10A.

In a case in which the antioxidant layer is layered on the pellicle film 11A, oxidation of the pellicle film 11A is suppressed during EUV light irradiation or pellicle storage. The antioxidant layer may be layered on only one surface of the pellicle film 11A.

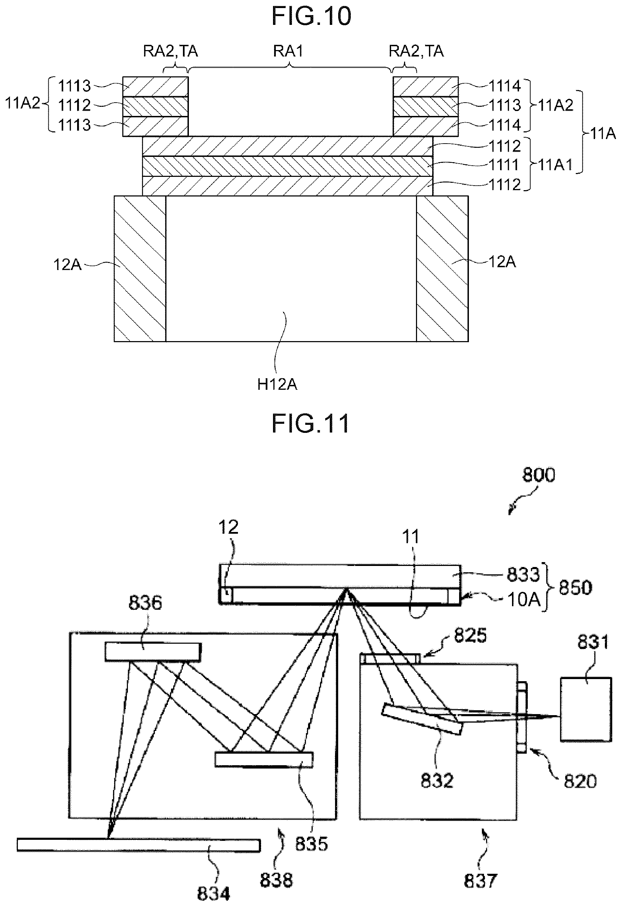

The pellicle film 11A may have a first film portion 11A1 and a second film portion 11A2, as illustrated in FIG. 10. The first film portion 11A1 has no through-hole. The second film portion 11A2 has no film portion in a region corresponding to the exposing region RA1. The second film portion 11A2 is layered on a surface of the first film portion 11A1, in which the surface is in a region (namely, peripheral border region RA2) corresponding to the thick film portion TA of the first film portion 11A1 and is opposite to the support frame 12A.

The first film portion 11A1 has a first CNT layer 1111 containing a carbon nanotube, and a coating layer 1112. The coating layer 1112 is formed on each of both main surfaces of the first CNT layer 1111.

The second film portion 11A2 has a second CNT layer 1113 containing a carbon nanotube, and a coating layer 1114. The coating layer 1114 is formed on each of both main surfaces of the second CNT layer 1113.

The total thickness of the first CNT layer 1111 and the second CNT layer 1113 in the thick film portion TA (namely, peripheral border region RA2) is from 1.5 times to 100 times the thickness of the first CNT layer 1111 in the exposing region RA1. Thus, not only the film thickness of the exposing region RA1 of the pellicle film 11A is decreased to increase the transmittance of exposure light, but also breakage of the pellicle film 11A due to the pressure difference inside and outside of the pellicle 10A can be suppressed.

Examples of each of the materials of the coating layer 1112 and the coating layer 1114 include B, B₄C, ZrN, Mo, Ru, SiC, TiN, and a-C.

### (1.2) Exposure Original Plate

An exposure original plate according to the first embodiment of the disclosure includes an original plate and the pellicle 10A mounted on the original plate.

The exposure original plate according to the first embodiment of the disclosure includes the pellicle 10A, and thus exerts the same effect as in the pellicle 10A.

In the first embodiment of the disclosure, a method of mounting the original plate to the pellicle 10A (hereinafter, also referred to as "mounting method") involves securing the original plate and the support frame 12A with the adhesive layer 13 for an original plate, located on one end surface of the support frame 12A, being interposed.

The mounting method is not limited to such a method of securing the original plate and the support frame 12A with the adhesive layer 13 for an original plate being interposed. The mounting method may involve, for example, allowing the original plate to directly adhere to the support frame 12A, or securing the original plate and the support frame 12A by using a mechanical securing method or an attraction force by a magnet or the like.

The original plate includes a support substrate, a reflection layer, and an absorber layer. The reflection layer is formed on the support substrate. The absorber is formed on the reflection layer. In this case, the pellicle 10A is mounted on a surface of the original plate, in which the surface faces the reflection layer and the absorber layer provided.

The absorber layer partially absorbs light (for example, EUV light), whereby a desired image is formed on a sensitive substrate (for example, photoresist film-attached semiconductor substrate). The reflection layer can be a multi-layer film of molybdenum (Mo) and silicon (Si). The absorber layer can include a material high in absorbability of EUV light or the like, such as chromium (Cr) or tantalum nitride.

### (1.3) Exposure Device

An exposure device according to the first embodiment of the disclosure includes a light source, the exposure original plate according to the first embodiment of the disclosure, and an optical system. The light source emits exposure light. The optical system guides exposure light emitted from the light source, to the exposure original plate. The exposure original plate is placed so that the exposure light emitted from the light source penetrates the pellicle film 11A and the original plate is irradiated with the exposure light.

Thus, the exposure device according to the first embodiment of the disclosure exerts the same effect as in the exposure original plate according to the first embodiment of the disclosure.

The exposure device according to the first embodiment of the disclosure includes a light source that emits exposure light, the exposure original plate according to the first embodiment of the disclosure, and an optical system that guides the exposure light emitted from the light source, to the exposure original plate, in which the exposure original plate is placed so that the exposure light emitted from the light source penetrates the pellicle film and the original plate is irradiated with the exposure light.

According to the aspect, not only a fine pattern (for example, a line width of 32 nm or less) can be formed by EUV light or the like, but also pattern exposure reduced in resolution failure due to foreign substances can be performed even in the case of use of EUV light easily causing the problem of resolution failure due to foreign substances.

The exposure light in the first embodiment of the disclosure is preferably EUV light.

### (1.4) Method of Producing Pellicle

Hereinafter, a method of producing the pellicle according to the first embodiment of the disclosure will be described.

Examples of the method of producing the pellicle according to the first embodiment of the disclosure include a first production method and a second production method.

Hereinafter, the first production method and the second production method will be described in the listed order.

### (1.4.1) First Production Method

The first production method of the disclosure is
a method of producing the pellicle 10A, including
a step of preparing the support frame 12A (hereinafter, also referred to as "first support frame preparation step"),
a step of preparing a first film (hereinafter, also referred to as "first film preparation step"),
a step of preparing a second film (hereinafter, also referred to as "second film preparation step"),
a first connection step of connecting the support frame 12A to a portion of one main surface of the first film, and
a layering step of layering the second film on at least a region of other main surface of the first film, the region corresponding to the peripheral border region RA2 (namely, thick film portion TA), to form the pellicle film 11A.

One of the first film and the second film has a through-hole passing through a region corresponding to the exposing region RA1 (hereinafter, also simply referred to as "through-hole").

In the first production method, one of the first film and the second film has a through-hole, whereby the pellicle 10A, in which the film thickness of the peripheral border region RA2 (namely, thick film portion TA) is thicker than the film thickness of the exposing region RA1, is obtained. In other words, according to the first production method, the pellicle 10A, in which breakage of the pellicle film 11A due to the pressure difference inside and outside of the pellicle 10A can be suppressed, is obtained.

The layering step and the first connection step are carried out after the first support frame preparation step, the first film preparation step, and the second film preparation step are carried out. The order of carrying out the first support frame preparation step, the first film preparation step, and the second film preparation step is not particularly limited. The order of carrying out each of the layering step and the first connection step is not particularly limited.

The second film preferably has a through-hole. Thus, the pellicle 10A, in which the support frame 12A, the first film having no through-hole, and the second film having a through-hole are placed in the listed order, is obtained. Therefore, foreign substances due to a through-hole can be prevented from entering the opening H12A. Such foreign substances due to a through-hole include fibers waste of the pellicle film 11A.

Hereinafter, a case in which the second film has a through-hole and the first connection step and the layering step are carried out in the listed order will be described.

### (1.4.1.1) First Film Preparation Step

In the first film preparation step, the first film is prepared.

The method of preparing the first film is not particularly limited, and, for example, the first film may be formed on a substrate.

The first film may include CNT. Hereinafter, a case in which the first film includes CNT will be described.

The first film preparation step may have a step of preparing CNT (hereinafter, also referred to as "CNT preparation step"), and a step of forming CNT into a sheet shape, to produce the first film (hereinafter, also referred to as "CNT film production step"). The CNT preparation step and the CNT film production step are carried out in the listed order.

In the CNT preparation step, CNT is prepared.

CNT may be obtained as a commercially available product, or may be obtained by production.

CNT here used is preferably one formed on a base material for chemical vapor deposition, by a CVD (Chemical Vapor Deposition method) method in which a metal catalyst is present in the reaction system and an oxidant is added to the reaction atmosphere.

The CVD method encompasses a plasma CVD method, low-pressure CVD, or a thermal CVD method.

The oxidant here used is water vapor. The concentration of such water vapor may be from 10 ppm to 10000 ppm, or such water vapor may also be added under an environment at a temperature of from 600°C to 1000°C.

CNT may also be synthesized by placing or patterning a metal catalyst on a base material for chemical vapor deposition.

CNT obtained may be a single layer or a multi-layer, or may be CNT provided in a direction perpendicular to a surface of a base material for chemical vapor deposition.

For example, CNT can be produced with reference to WO 2006/011655 or the like.

Examples of such a commercially available product of CNT include CNT according to a super-growth production method, sold by Zeon Corporation.

CNT (that may be a CNT bulk structure) here used is preferably one produced by an enhanced direct injection pyrolytic synthesis method (hereinafter, also referred to as "e-DIPS method").

A direct injection pyrolytic synthesis method (hereinafter, also referred to as "DIPS method") is a vapor-phase flow method. Particularly, the DIPS method involves spraying and atomizing a hydrocarbon-based solution containing a catalyst (or catalyst precursor) and a reaction promotor and introducing the resultant to a high-temperature heating furnace, thereby synthesizing single-layer CNT in a vapor phase fluidized.

The e-DIPS method is a vapor-phase flow method obtained by enhancing the DIPS method. Particularly, the "e-DIPS method" focuses on a particle formation process providing the different in particle size of ferrocene used as a catalyst between the upstream and the downstream of a reaction furnace, and allows for relatively easy decomposition in a carrier gas unlike the DIPS method using only an organic solvent for a carbon source. In other words, the e-DIPS method is a method involving mixing a second carbon source easily serving as a carbon source, to control a growth point of single-layer CNT.

Specifically, CNT can be produced with reference to Saito et al., J. Nanosci. Nanotechnol., 8 (2008) 6153-6157.

Examples of such a commercially available product of CNT include trade name "MEIJOeDIPS" manufactured by Meijo Nano Carbon.

In the CNT film production step, CNT is formed into a sheet shape, to produce the first film.

CNT (or CNT bulk structure) obtained by the CVD method, the e-DIPS method, or the like is used in the state of being dispersed in a solvent.

A liquid in which CNT (or CNT bulk structure) is dispersed (dispersion liquid) is applied onto a substrate, and the solvent is evaporated and removed, whereby a CNT film is formed on the substrate.

In the first embodiment of the disclosure, the solvent used in the dispersion liquid is removed, whereby a film in which CNT is substantially in parallel with a surface of the substrate is obtained.

The application method is not particularly limited, and, for example, spin coating, dip coating, bar coating, spray coating, or electrospray coating may be used.

While a metal catalyst used in CNT formation may cause a reduction in EUV transmittance, the metal catalyst is almost not included in CNT in release of CNT from a base material for chemical vapor deposition, and thus has no influence.

The substrate here used may be an inorganic material.

For example, the substrate here used may be silicon (Si). The substrate is not limited to silicon (Si), may be a semiconductor material such as germanium (Ge), silicon germanium (SiGe), silicon carbide (SiC), or gallium arsenide (GaAs), may be a glass substrate such as a quartz glass substrate (silicon oxide (SiO₂)), a soda glass substrate, a borosilicate glass substrate, or a sapphire substrate, or may be silicon nitride (SiN), an aluminum nitride (AlN) substrate, a zirconia (ZrO₂) substrate, or aluminum oxide (Al₂O₃).

The substrate preferably includes at least any of silicon, sapphire, and silicon carbide whose linear thermal expansion coefficients are close to that of the first film, from the viewpoint of a reduction in thermal strain with the CNT film.

Silicon (Si) may be any of monocrystal silicon, polycrystal silicon, microcrystal silicon, and amorphous silicon, and monocrystal silicon is preferable from the viewpoint of etching efficiency and from the viewpoint of high general versatility and inexpensive price.

The shape of the substrate is not particularly limited, and may be circular or rectangular.

The thickness of the substrate is not particularly limited, and is from 100 µm to 1000 µm and preferably from 200 µm to 1000 µm from the viewpoint of handling.

A procedure may also be used which involves dropping the dispersion liquid in which CNT is dispersed, onto a paper filter, to remove the solvent, thereby forming the CNT film on the paper filter.

### (1.4.1.2) Second Film Preparation Step

In the second film preparation step, the second film is prepared.

The method of preparing the second film is not particularly limited, and, for example, the second film may be formed on the substrate.

The second film may include CNT. In a case in which the second film includes CNT, the second film preparation step may be the same as the first film preparation step.

The second film preparation step has a step of forming a through-hole in the second film.

The method of forming a through-hole in the second film is not particularly limited, and examples include a method of mechanically scrubbing the first film, a chemical etching method, an ablation method by laser light, a method involving applying masking on the substrate on which the first film is to be formed, and forming a through-hole in a film formation process, and a method of film formation by a spray coating method or an ink-jet method so that a through-hole is formed.

Each of the first film and the second film preferably includes CNT, and is more preferably formed from CNT. Each of the first film and the second film is formed from CNT, whereby the resulting pellicle film 11A can be a thin film excellent in mechanical strength, and the transmittance of exposure light of the pellicle film can be higher.

### (1.4.1.3) First Support Frame Preparation Step

In the first support frame preparation step, the support frame 12A is prepared. The support frame 12A prepared has the opening H12A.

The method of preparing the support frame 12A may be a known method.

### (1.4.1.4) First Connection Step

In the first connection step, the support frame 12A is connected to a portion of one main surface of the first film. Particularly, in the first connection step, the first film is connected to the support frame 12A so that the opening H12A of the support frame 12A having the opening H12A is covered.

In the first connection step, the first film and the substrate may be separated and then the first film separated may be connected to the support frame 12A (namely, pellicle frame).

The method of separating the first film and the substrate is not particularly limited, and, for example, the following production example is shown.

### (1.4.1.4.1) Method with Sacrifice Layer

A self-supporting film can be obtained by layering a sacrifice layer on the substrate and forming the first film thereon, and thereafter removing the sacrifice layer.

The sacrifice layer can be a metal, an oxidized film, a resin, a salt, or the like that can be removed by a specified treatment method. For example, the sacrifice layer can be a metal soluble in an acidic solution, such as aluminum. Specifically, the first film can be released from a glass substrate or a silicon substrate by layering a metal layer on a surface of the substrate by deposition, sputtering, or the like, further layering the first film on the metal layer, and then immersing the resultant in a solution that can dissolve the metal layer, such as an acidic solution.

In a case in which a silicon substrate having a natural oxide film or a silicon oxide layer is used as the substrate, the first film can also be released from the substrate by coating the natural oxide film or the silicon oxide layer on the silicon substrate with the first film and then immersing the resultant in an aqueous hydrofluoric acid solution, to remove the natural oxide film or the silicon oxide layer.

The material of the sacrifice layer layered on the substrate may be a water-soluble material such as a partially saponified polyvinyl alcohol resin or a salt such as sodium chloride. The first film can be released from the substrate by layering the first film on the sacrifice layer, to obtain a layered body, and immersing the layered body obtained, in water.

In the case of selection of the method of removing the sacrifice layer layered on the substrate, any procedure that is most appropriate can be selected depending on characteristics such as process resistance of the first film, film strength, the removal rate of the sacrifice layer, and film thickness uniformity and surface roughness of the sacrifice layer.

### (1.4.1.4.2) Etching or Dissolution of Substrate

In a case in which the material of the substrate is a metal, an oxidized film, a resin, a salt, or the like that can be removed by a specified treatment method, the first film can be obtained by layering the first film on the substrate and then etching or dissolving the substrate.

For example, in a case in which copper foil is used as the substrate, the first film can be obtained by layering the first film on a surface of the copper foil and then immersing the resultant in a cupric chloride etching liquid, to etch such a copper foil substrate and thus remove the substrate.

In a case in which the substrate is a glass substrate, the first film can be obtained by layering the first film on the glass substrate and then etching the glass substrate with hydrofluoric acid, to remove the substrate.

In a case in which the substrate is a silicon substrate, the first film can be obtained by layering the first film on the silicon substrate and then etching the silicon substrate by wet etching or dry etching, to remove the silicon substrate.

The wet etching can be made with an etching liquid such as KOH, TMAH, or hydrazine. The dry etching can be made with an etching gas such as a fluorine-based (SF₆, CF₄, NF₃, PFs, BF₃, CHF₃, XeF₂, F₂+NO), chloride-based (Cl₂, SiCl₄), or bromine-based (IBr) etching gas. The wet etching rate is changed by the temperature, and thus it is preferable for etching without any damage on the first film containing CNT on the silicon substrate to decrease the liquid temperature and decrease the etching rate.

In a case in which the silicon substrate is dry etched, a layer such as an etching stop layer may also be provided on a surface of the silicon substrate in advance.

Examples of the etching stop layer include a layer including SiO₂ or SiN. The etching stop layer is preferably configured from a film in which tensile stress is to be generated.

Residual stress that acts in a parallel direction with surfaces of a substrate and a film includes tensile stress and compression stress. Such residual stress acts as tensile stress in the case of action of force for aiming to expand a film inward, and acts as compression stress in the case of action of force for aiming to contract a film inward. Such stress is mainly generated in the course of film formation.

One factor producing such residual stress is the difference in thermal expansion coefficient between a substrate and a film. Both a substrate and a film, while are contracted during turning back to room temperature, are different in proportion of contraction due to the thermal expansion coefficients, and tensile stress acts in a case in which the thermal expansion coefficient of a film is larger than the thermal expansion coefficient of a substrate, and compression stress acts in the case of vice versa. A film in which tensile stress is to be generated is preferable because of allowing for application of tension to the first film provided on the film, thereby making the first film wrinkleless. Since a layer including SiN generates tensile stress, the first film, which is obtained by dry etching the silicon substrate, can be a wrinkleless film. The etching stop layer is removed after the termination of dry etching of the silicon substrate, whereby an objective self-supporting film can be obtained.

In a case in which the substrate is a substrate including a salt such as sodium chloride, the first film can be obtained by layering the first film on a surface of the substrate and then immersing the resultant in water, to etch the substrate and remove the substrate.

In a case in which the substrate is a plastic substrate, the first film can be obtained by layering the first film on a surface of the plastic substrate and then immersing the resultant in a solvent that can dissolve the plastic substrate, to dissolve the plastic substrate.

### (1.4.1.4.3) Surface Treatment

The first film can be easily released from the substrate by subjecting the substrate to surface treatment, to control interaction between the first film and a surface of the substrate, and performing immersion in a solvent and a mechanical release process.

Examples of the method of controlling the interaction between the first film and a surface of the substrate include a surface treatment method with a silane coupling agent. Other examples include a method of cleaning a surface of the substrate with water, an organic solvent, a piranha solution, sulfuric acid, a UV ozone treatment, or the like.

In a case in which the substrate is a silicon substrate, a solution used for an RCA cleaning method, such as a mixed liquid of hydrogen peroxide water and ammonium hydroxide or a mixed liquid of hydrochloric acid and hydrogen peroxide water can be used.

The method of etching or dissolving the substrate may be used in combination in formation of the sacrifice layer or surface treatment of the substrate. A preferable substance used in the formation of the sacrifice layer or the surface treatment is a substance that hardly remains in a surface, an inside, and the like of the first film and that can be removed by a simple method even in a case in which the substance remains in a surface, an inside, and the like of the first film.

Examples include etching with gas, evaporation by heat, cleaning by a solvent, and decomposition and removal by light, and these may be combined for performing removal.

### (1.4.1.5) Layering Step

In the layering step, the second film is layered on at least a region of other main surface of the first film, the region corresponding to the peripheral border region, thereby forming the pellicle film 11A.

In the layering step, the second film and the substrate may be separated and then the second film separated may be layered on the first film.

The method of separating the second film and the substrate is not particularly limited, and examples include the same method as the method exemplified as the method of separating the first film and the substrate.

The method of layering the second film separated, on the first film, is not particularly limited, and examples include a method involving taking up the second film floating on a water liquid surface, by the support frame 12A to which the first film is connected, and a method of forming and layering the second film on the first film by a spray coating method or an ink-jet method.

The pellicle film 11A preferably includes a layered film in which two or more CNT films each including a carbon nanotube are layered. Thus, the resulting pellicle film is more favorable in mechanical strength.

The number of such carbon nanotube films constituting the layered film may be 2 or more, and is preferably from 2 to 30, more preferably from 3 to 10.

Examples of such a carbon nanotube film include a sheet-shaped object of CNT, exemplified as the first film, and a film including CNT, exemplified as the second film.

### (1.4.1.6) Adhesive Layer Formation Step

In the first of the disclosure, the method of producing the pellicle 10A includes an adhesive layer formation step. The adhesive layer formation step is carried out, whereby an original plate such as a photomask and the support frame 12A can adhere with the adhesive layer 13 for an original plate being interposed.

In the adhesive layer formation step, the adhesive is applied to a surface in the opening of the support frame 12A, in which the surface is opposite to one to which the pellicle film 11A is to be connected.

A separator may be placed so as to be contacted with a surface of the formed adhesive layer 13 for an original plate, in which the surface is opposite to the support frame 12A. Thus, the pellicle 10A can be stored with adhesiveness of the adhesive layer 13 for an original plate being kept, until the original plate and the support frame 12A adhere to each other with the adhesive layer 13 for an original plate being interposed.

The method of producing the pellicle 10A does not necessarily include the adhesive layer formation step.

### (1.4.2) Second Production Method

The second production method of the disclosure is
a method of producing the pellicle 10A, including
a step of preparing the support frame 12A (hereinafter, also referred to as "second support frame preparation step"),
a step of preparing the pellicle film 11A (hereinafter, also referred to as "pellicle film preparation step"), and
a second connection step of connecting the support frame 12A to the pellicle film 11A.

According to the second production method of the disclosure, the pellicle 10A, in which breakage of the pellicle film 11A due to the pressure difference inside and outside of the pellicle 10A can be suppressed, is obtained.

The second connection step is carried out after the second support frame preparation step and the pellicle film preparation step are carried out. The order of carrying out each of the second support frame preparation step and the pellicle film preparation step is not particularly limited.

### (1.4.2.1) Pellicle Film Preparation Step

In the pellicle film preparation step, the pellicle film 11A is prepared.

The pellicle film preparation step may be a step of simply preparing the pellicle film 11A produced in advance, or may be a step of producing the pellicle film 11A.

In a case in which the pellicle film preparation step is a step of producing the pellicle film 11A, a method of preparing the pellicle film 11A is, if appropriate, selected depending on the type of the pellicle film 11A.

The method of preparing the pellicle film 11A may include the first film preparation step and the second film preparation step.

The pellicle film 11A preferably has a carbon nanotube and the thick film portion TA (namely, peripheral border region RA2) is preferably formed by a spray coating method or an ink-jet method.

The spray coating method or the ink-jet method may be a known method.

### (1.4.2.2) Second Support Frame Preparation Step

The second support frame preparation step is carried out in the same manner as in the first support frame preparation step.

### (1.4.2.3) Second Connection Step

In the second connection step, the pellicle film 11A is connected to the support frame 12A. Particularly, in the second connection step, the pellicle film 11A is connected to the support frame 12A so that the opening H12A of the support frame 12A having the opening H12A is covered.

In the second connection step, for example, the pellicle film 11A and the substrate may be separated and then the pellicle film 11A separated may be connected to the support frame 12A.

The method of separating the pellicle film 11A and the substrate is the same as the method exemplified as the method of separating the first film and the substrate.

The method of connecting the pellicle film 11A separated, to the support frame 12A, is not particularly limited, and examples include a method involving taking up the pellicle film 11A floating on a water liquid surface, by the support frame 12A.

### (1.5) Method of Producing Semiconductor Device

A method of producing a semiconductor device according to the first embodiment of the disclosure includes a reflection step and an exposure step. In the reflection step, exposure light emitted from a light source is allowed to penetrate the pellicle film 11A of an exposure original plate, to irradiate the original plate with the exposure light and reflect the exposure light by the original plate. In the exposure step, the exposure light reflected by the original plate is allowed to penetrate the pellicle film 11A, to irradiate a sensitive substrate with the exposure light, thereby exposing the sensitive substrate in a pattern shape. The reflection step and the exposure step are carried out in the listed order.

According to the method of producing a semiconductor device according to the first embodiment of the disclosure, a semiconductor device reduced in resolution failure due to foreign substances is obtained even in the case of use of EUV light easily causing the problem of resolution failure due to foreign substances.

Hereinafter, one example of the method of producing a semiconductor device according to the first embodiment of the disclosure will be described with reference to FIG. 11.

FIG. 11 is a schematic cross-sectional view of an EUV exposure device 800 as the exposure device according to the first embodiment of the disclosure.

As illustrated in FIG. 11, the EUV exposure device 800 includes a light source 831 that emits EUV light, an exposure original plate 850 as one example of the exposure original plate of the disclosure, and an illumination optical system 837 that guides the EUV light emitted from the light source 831, to the exposure original plate 850.

The exposure original plate 850 includes the pellicle 10A including the pellicle film 11A and the support frame 12A, and an original plate 833. The exposure original plate 850 is placed so that EUV light emitted from the light source 831 penetrates the pellicle film 11A and the original plate 833 is irradiated with the EUV light.

The original plate 833 reflects the EUV light for irradiation, in a pattern shape.

In the EUV exposure device 800, filters/windows 820 and 825 are respectively disposed between the light source 831 and the illumination optical system 837, and between the illumination optical system 837 and the original plate 833.

The EUV exposure device 800 includes a projection optical system 838 that guides the EUV light reflected by the original plate 833, to a sensitive substrate 834.

In the EUV exposure device 800, the EUV light reflected by the original plate 833 is guided through the projection optical system 838 onto the sensitive substrate 834, and the sensitive substrate 834 is exposed in a pattern shape. The exposure by EUV is performed under a reduced pressure condition.

The EUV light source 831 emits EUV light toward the illumination optical system 837.

The EUV light source 831 includes a target material, a pulse laser irradiation portion, and/or the like. EUV is obtained by irradiating the target material with pulse laser, to generate plasma. In a case in which the target material is Sn, EUV of a wavelength of from 13 nm to 14 nm is obtained. The wavelength of light emitted from the EUV light source is not limited to from 13 nm to 14 nm, and may be a wavelength suitable for an object, in a wavelength range of from 5 nm to 30 nm.

The illumination optical system 837 collects light radiated from the EUV light source 831 and homogenizes the intensity of illumination, to irradiate the original plate 833 with the light.

The illumination optical system 837 includes a plurality of multi-layer film mirrors 832 for adjustment of a light path of EUV, an optical coupler (optical integrator), and the like. Such a multi-layer film mirror is a multi-layer film in which molybdenum (Mo) and silicon (Si) are alternately layered.

The method of mounting the filters/windows 820 and 825 is not particularly restricted, and examples include a method of adhesion with an adhesive, and a method of mechanical securement into the EUV exposure device.

The filter/window 820 placed between the light source 831 and the illumination optical system 837 is to trap a scattering particle (debris) generated from the light source, not to cause attachment of the scattering particle (debris) to any element (for example, multi-layer film mirrors 832) in the illumination optical system 837.

In this regard, the filter/window 825 placed between the illumination optical system 837 and the original plate 833 is to trap a particle (debris) scattered from the light source 831, not to cause attachment of the scattering particle (debris) to the original plate 833.

Foreign substances attached to the original plate absorb or scatter EUV light, thereby causing resolution failure to a wafer. Therefore, the pellicle 10A is mounted so as to cover an EUV light irradiation area of the original plate 833. EUV light passes through the pellicle film 11A and the original plate 833 is irradiated with the EUV light.

EUV light reflected by the original plate 833 passes through the pellicle film 11A, and the sensitive substrate 834 is irradiated with the EUV light through the projection optical system 838.

The projection optical system 838 collects light reflected by the original plate 833, to irradiate the sensitive substrate 834 with the light. The projection optical system 838 includes a plurality of multi-layer film mirrors 835 and 836 for preparing a light path of EUV

The sensitive substrate 834 is, for example, a substrate in which resist is applied onto a semiconductor wafer, and the resist is cured in a pattern shape by EUV reflected by the original plate 833. The resist is developed and the semiconductor wafer is etched, whereby a desired pattern is formed on the semiconductor wafer.

The pellicle 10A is mounted to the original plate 833 with the adhesive layer 13 for an original plate being interposed. Foreign substances attached to the original plate absorb or scatter EUV, thereby causing resolution failure to a wafer. Therefore, the pellicle 10A is mounted so as to cover an EUV light irradiation area of the original plate 833, and EUV passes through the pellicle film 11A and the original plate 833 is irradiated with this light.

The method of mounting the pellicle 10A to the original plate 833 may be a method that can allow for installation on the original plate so that no foreign substances are attached to a surface of the original plate, and examples include a method of adhesion of the support frame 12A and the original plate 833 by an adhesive, an electrostatic adsorption method, and a mechanical securing method, but not particularly limited thereto. A method of adhesion with an adhesive is preferably used.

While the method of layering the first film and the second film is disclosed as the production method of the disclosure, any other film may be layered in addition to these films.

### (2) Second Embodiment

### (2.1) Pellicle

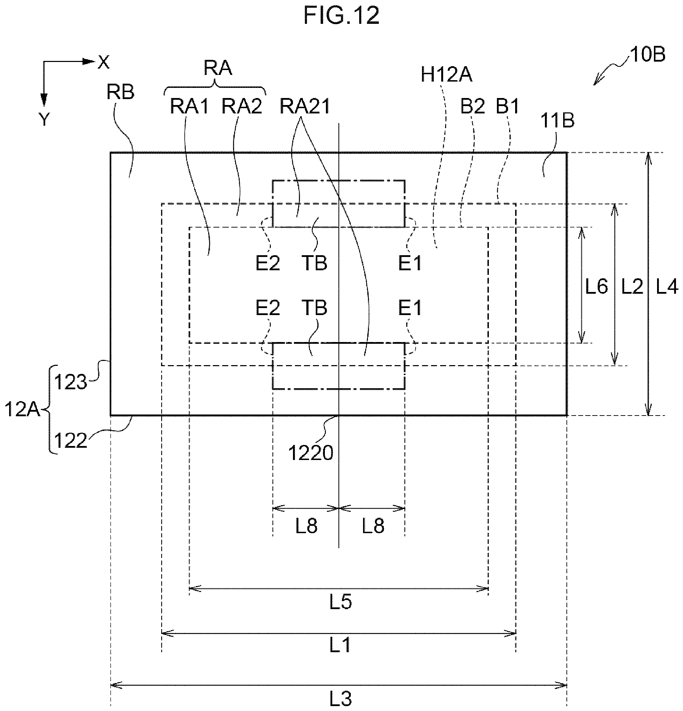

Hereinafter, a pellicle 10B according to the second embodiment of the disclosure will be described with reference to FIG. 12. The pellicle 10B satisfies (i). FIG. 12 is a top view illustrating an appearance of the pellicle 10B according to the second embodiment of the disclosure.

The pellicle 10B is the same as the pellicle 10A according to the first embodiment mainly except that the thick film portion is located along with only each center portion of a pair of longer sides of the support frame.

The pellicle 10B includes, as illustrated in FIG. 12, a pellicle film 11B and a support frame 12A. The support frame 12A has an opening H12A. The pellicle film 11B is supported by the support frame 12A. The pellicle film 11B is in contact with the support frame 12A.

The profile of the opening H12A of the support frame 12A in a planar view is oblong in the second embodiment of the disclosure, as illustrated in FIG. 12.

Hereinafter, a direction in which one side of the profile of the oblong opening H12A extends is defined as a left-right direction, in a planar view. A direction perpendicular to the left-right direction is defined as a front-back direction, in a planar view. The thickness direction of the support frame 12A is defined as an up-down direction. A surface of the pellicle film 11B, on which the support frame 12A is placed, is defined as a downside, and an opposite surface thereof is defined as an upside, in the up-down direction.

In FIG. 12, a rightside, a leftside, a front side, a backside, an upside, and a downside respectively correspond to an X-axis positive direction, an X-axis negative direction, a Y-axis positive direction, a Y-axis negative direction, a Z-axis positive direction, and a Z-axis negative direction.

### (2.1.1) Pellicle Film

The pellicle film 11B is different from the pellicle film 11A of the first embodiment in that no thick film portion TB is formed over the whore area of a peripheral border region RA2.

### (2.1.1.1) Self-Supporting Film Region and Supported Region

The pellicle film 11B has a self-supporting film region RA and a supported region RB in a planar view, as illustrated in FIG. 12.

The self-supporting film region RA contains an exposing region RA1 and a peripheral border region RA2 in a planar view, as illustrated in FIG. 12. The peripheral border region RA2 surrounds the exposing region RA1 in the pellicle film 11B. The exposing region RA1 and the peripheral border region RA2 are adjacent in the second embodiment of the disclosure.

The peripheral border region RA2 has a pair of longer side regions RA21. The support frame 12A is a rectangular frame formed by a pair of longer side portions 122 and a pair of shorter side portions 123. The pair of longer side regions RA21 is formed along the longer side portions 122 in an extending direction (X-axis direction) in which the longer side portions 122 extend.

The pair of longer side regions RA21 indicates a region between two locations E1 and E2 apart by a distance L8 (see FIG. 12) representing at least 5% of a length L1 (see FIG. 12), in the opening H12A, of each of the longer side portions 122, toward one direction (X-axis positive direction) and other direction (X-axis negative direction) from a center portion 1220 of each of the longer side portions 122 in the extending direction (X-axis direction), in the peripheral border region RA2.

The distance L8 corresponds to 5% or more with respect to the length L1, in the opening H12A, of each of the longer side portions 122, and preferably corresponds to from 7% to 49%, more preferably from 10% to 45% from the viewpoint of suppression of breakage of the pellicle film 11B due to the pressure difference inside and outside of the pellicle 10B.

The distance L8 is preferably from 7 mm to 70 mm, more preferably from 15 mm to 65 mm.

### (2.1.1.2) Film Thickness of Pellicle Film

The film thickness of the pair of longer side regions RA21 of the pellicle film 11B (namely, film thickness of a thick film portion TB) is thicker than the film thickness of the exposing region RA1. Thus, mechanical strength of the pair of longer side regions RA21 is higher than mechanical strength of the exposing region RA1. As described above with reference to FIG. 4, stress to the pellicle film, generated due to the pressure difference inside and outside of the pellicle, is easily increased in the pair of longer side regions RA21 of the pellicle film 11B. As a result, the pellicle film 11B can be suppressed in breakage of the pellicle film 11B due to the pressure difference inside and outside of the pellicle 10B as compared with a configuration in which the film thickness of the pair of longer side regions RA21 and the film thickness of the exposing region RA1 are the same. In particular, the thick film portion is provided so as to step across an edge portion of the support frame 12A from the peripheral border region RA2 to an outer edge of the support frame 12A, whereby breakage of the pellicle film 11B due to stress concentration to the pellicle film 11B on the edge portion of the support frame 12A can be easily suppressed.

The ratio of each film thickness of the pair of longer side regions RA21 (namely, the film thickness of the thick film portion TB) to the film thickness of the exposing region RA1 is preferably from 1.5 times to 100 times. Thus, not only breakage of the pellicle film 11B due to the pressure difference inside and outside of the pellicle 10B can be more suppressed, but also production cost is excellent.

The lower limit of the ratio of the film thickness of the pair of longer side regions RA21 to the film thickness of the exposing region RA1 is more preferably 1.9 times or more, still more preferably 5 times or more, particularly preferably 10 times or more from the viewpoint of further suppression of breakage of the pellicle film 11B due to the pressure difference inside and outside of the pellicle 10B.

The upper limit of the ratio of the film thickness of the pair of longer side regions RA21 to the film thickness of the exposing region RA1 is preferably 70 times or less, more preferably 50 times or less from the viewpoint of production cost.

The thick film portion TB may be at least located in the pair of longer side regions RA21, may be located in only the pair of longer side regions RA21, or may be further located in, in addition to the pair of longer side regions RA21, a region different from the pair of longer side regions RA21.

Examples of the region different from the pair of longer side regions RA21 include a pair of shorter side regions.

The pair of shorter side regions is formed along the shorter side portions 123 in an extending direction (Y-axis direction) in which the shorter side portions extend. The pair of shorter side regions indicates a region between two locations apart by a distance representing at least 5% of a length L2, in the opening H12A, of each of the shorter side portions 123, toward one direction (Y-axis positive direction) and other direction (Y-axis negative direction) from a center portion of each of the shorter side portions 123 in an extending direction (Y-axis direction) in which the shorter side portions 123 extend, in the peripheral border region RA2.

### (2.1.1.3) Method of Measuring Film Thickness

The method of measuring each of the film thickness of the exposing region RA1 and the film thickness of the pair of longer side regions RA21 is the same as the method of measuring each of the film thickness of the exposing region RA1 and the film thickness of the peripheral border region RA2 of the pellicle film 11A.

### (2.1.1.4) Structure of Pellicle Film

The structure of the pellicle film 11B is not particularly limited, and may be a single-layer structure or a layered structure. In particular, the structure of the pellicle film 11B is a layered structure from the viewpoint of, for example, ease of production of the pellicle film 11B. The layered structure is, for example, a layered body of a first film portion (hereinafter, also referred to as "unprocessed film") and a pair of third film portions (hereinafter, also referred to as "pair of second processed films"). The pair of second processed films is a flat film containing a region corresponding to the pair of longer side regions RA21 (pair of thick film portions TB). In other words, the second processed films each have no film portion in the region corresponding to the exposing region RA1. The unprocessed film and the pair of second processed films each may be a single-layer film or may be a layered film in which a plurality of single-layer films is layered. The respective materials in the plurality of single-layer films may be the same as or different from each other.

The pair of second processed films may be located on a surface of the pellicle film 11B, in which the surface faces the support frame 12A, or may be located on a surface of the pellicle film 11B, in which the surface is opposite to the support frame 12A. In particular, the pair of second processed films is preferably layered on a surface of the unprocessed film, in which the surface faces the support frame 12A, from the viewpoint of, for example, preventing foreign substances from entering the opening H12A through an inner peripheral wall of the through-hole of each of the second processed films. That is, the pair of second processed films is preferably located on a surface of the pellicle film 11B, in which the surface is opposite to the support frame 12A. In other words, the support frame 12A, the unprocessed film, and the pair of second processed films are preferably placed in the listed order in the upper direction (Z-axis positive direction) from the lower direction (Z-axis negative direction). Such foreign substances entering through the pair of second processed films include fibers waste of the pair of second processed films.

### (2.1.1.5) Material of Pellicle Film

The material of the pellicle film 11B is not particularly limited, and examples thereof include each material exemplified as the material of the pellicle film 11A.

In a case in which the pellicle film 11B has a layered structure, the material of the unprocessed film and the material of the pair of second processed films may be the same as or different from each other.

In particular, the material of the pellicle film 11B preferably includes a carbon nanotube. The pellicle film 11B is a CNT film, whereby favorable mechanical strength can be obtained.

### (2.1.1.5.1) Antioxidant Layer

Other layer may be layered on the pellicle film 11B.

An antioxidant layer may be layered on at least one surface of the pellicle film 11B. Examples of the antioxidant layer include the same as those exemplified for the antioxidant layer that may be layered on the pellicle film 11A.

In a case in which the pellicle film 11B includes a CNT film and other layer is layered on the CNT film, the film thickness of the CNT film is thicker than the film thickness of such other layer.

In a case in which the pellicle film 11B includes a CNT film and other layer is layered on the CNT film, the outermost layer among layers constituting the pellicle film 11B is preferably such other layer.

In a case in which the pellicle film 11B includes a CNT film and other layer is layered on the CNT film, another aspect is such that the film thickness of the CNT film with respect to the film thickness of the entire pellicle film 11B including such other layer is preferably 50% or more, still more preferably 70% or more.

### (2.1.1.6) Physical Properties of Pellicle Film

Physical properties of the pellicle film 11B preferably include physical properties that are the same as physical properties exemplified as physical properties of the pellicle film 11A.

### (2.1.2) Variation

The pellicle film 11B may have a first film portion and a second film portion. The first film portion has no through-hole. The second film portion has no film portion in a region corresponding to the exposing region RA1. The second film portion is layered on a surface of the first film portion, in which the surface is in a region (namely, pair of longer side regions RA21) corresponding to the thick film portion TB of the first film portion and is opposite to the support frame 12A.

The first film portion is the same as that exemplified as the first film portion 11A1 (see FIG. 10) in the variation of the first embodiment. The second film portion is the same as that exemplified as the second film portion 11A2 (see FIG. 10) in the variation of the first embodiment except that the second film portion is layered on a region (namely, pair of longer side regions RA21) corresponding to the thick film portion TB of the first film portion.

### (2.2) Exposure Original Plate

An exposure original plate according to the second embodiment of the disclosure includes an original plate, and the pellicle 10B mounted on the original plate.

The exposure original plate according to the second embodiment of the disclosure includes the pellicle 10B, and thus exerts the same effect as in pellicle 10B.

The exposure original plate according to the second embodiment of the disclosure is the same as the exposure original plate according to the first embodiment of the disclosure except that the pellicle 10B is used instead of the pellicle 10A.

### (2.3) Exposure Device

An exposure device according to the second embodiment of the disclosure includes a light source, the exposure original plate according to the second embodiment of the disclosure, and an optical system. The light source emits exposure light. The optical system guides exposure light emitted from the light source, to the exposure original plate. The exposure original plate is placed so that the exposure light emitted from the light source penetrates the pellicle film 11B and the original plate is irradiated with the exposure light.

Thus, the exposure device according to the second embodiment of the disclosure exerts the same effect as in the exposure original plate according to the second embodiment of the disclosure.

The exposure device according to the second embodiment of the disclosure is the same as the exposure device according to the first embodiment except that the exposure original plate according to the second embodiment of the disclosure is used instead of the exposure original plate according to the first embodiment of the disclosure.

### (2.4) Method of Producing Pellicle

Examples of the method of producing the pellicle according to the second embodiment of the disclosure include a third production method and a fourth production method.

Hereinafter, the third production method and the fourth production method will be described in the listed order.

### (2.4.1) Third Production Method

The third production method of the disclosure is
a method of producing the pellicle 10B, including
a step of preparing the support frame 12A,
a step of preparing a first film,
a step of preparing a second film,
a first connection step of connecting the support frame 12A to a portion of one main surface of the first film, and
a layering step of layering the second film on at least a region of other main surface of the first film, the region corresponding to the pair of longer side regions RA21 (namely, thick film portion TB), to form the pellicle film 11B.

According to the third production method, the pellicle 10B, in which breakage of the pellicle film 11B due to the pressure difference inside and outside of the pellicle 10B can be suppressed, is obtained.

The third production method of the disclosure is the same as the first production method of the disclosure except for layering the second film on at least a region of other main surface of the first film, the region corresponding to the pair of longer side regions RA21 (namely, thick film portion TB), instead of layering the second film on at least a region of other main surface of the first film, the region corresponding to the peripheral border region RA2 (namely, thick film portion TA).

### (2.4.2) Fourth Production Method

The fourth production method of the disclosure is
a method of producing the pellicle 10B, including
a step of preparing the support frame 12A,
a step of preparing the pellicle film 11B, and
a second connection step of connecting the support frame 12A to the pellicle film 11B.

According to the fourth production method of the disclosure, the pellicle 10B, in which breakage of the pellicle film 11B due to the pressure difference inside and outside of the pellicle 10B can be suppressed, is obtained.

The fourth production method of the disclosure is the same as the second production method of the disclosure except for preparing the pellicle film 11B instead of preparing the pellicle film 11A.

A method of preparing the pellicle film 11B is not particularly limited. For example, the pellicle film 11B may have a carbon nanotube and the thick film portion TB (namely, pair of longer side regions RA21) may be formed by a spray coating method or an ink-jet method.

The spray coating method or the ink-jet method may be a known method.

### (2.5) Method of Producing Semiconductor Device

A method of producing a semiconductor device according to the second embodiment of the disclosure includes a reflection step and an exposure step. In the reflection step, exposure light emitted from a light source is allowed to penetrate the pellicle film 11B of an exposure original plate, to irradiate the original plate with the exposure light and reflect the exposure light by the original plate. In the exposure step, the exposure light reflected by the original plate is allowed to penetrate the pellicle film 11B, to irradiate a sensitive substrate with the exposure light, thereby exposing the sensitive substrate in a pattern shape. The reflection step and the exposure step are carried out in the listed order.

According to the method of producing a semiconductor device according to the second embodiment of the disclosure, a semiconductor device reduced in resolution failure due to foreign substances is obtained even in the case of use of EUV light easily causing the problem of resolution failure due to foreign substances.

The method of producing a semiconductor device according to the second embodiment of the disclosure is the same as the method of producing a semiconductor device according to the first embodiment of the disclosure except that the pellicle film 11B is used instead of the pellicle film 11A.

### (3) Third Embodiment

### (3.1) Pellicle

Hereinafter, a pellicle 10C according to the third embodiment of the disclosure will be described with reference to FIG. 13. The pellicle 10C satisfies (ii). FIG. 13 is a top view illustrating an appearance of the pellicle 10C according to the third embodiment of the disclosure.

The pellicle 10C is the same as the pellicle 10A according to the first embodiment mainly except that the support frame is square and the thick film portion is located along with each center portion of four sides of the support frame.

The pellicle 10C includes, as illustrated in FIG. 13, a pellicle film 11C and a support frame 12C. The support frame 12C has an opening H12C. The pellicle film 11C is supported by the support frame 12C. The pellicle film 11C is in contact with the support frame 12C.

The profile of the opening H12C of the support frame 12C in a planar view is a square in the third embodiment of the disclosure, as illustrated in FIG. 13.

Hereinafter, a direction in which a pair of first side portions in parallel with each other, of the profile of the square opening H12C, extends is defined as a left-right direction, in a planar view. A direction in which a pair of second side portions in parallel with each other, of the profile of the square opening H12C, extends is defined as a front-back direction, in a planar view. The thickness direction of the support frame 12C is defined as an up-down direction. A surface of the pellicle film 11C, on which the support frame 12C is placed, is defined as a downside, and an opposite surface thereof is defined as an upside, in the up-down direction.

In FIG. 13, a rightside, a leftside, a front side, a backside, an upside, and a downside respectively correspond to an X-axis positive direction, an X-axis negative direction, a Y-axis positive direction, a Y-axis negative direction, a Z-axis positive direction, and a Z-axis negative direction.

### (3.1.1) Pellicle Film

The pellicle film 11C is different from the pellicle film 11A of the first embodiment in that no thick film portion TC is formed over the whore area of a peripheral border region RA2.

### (3.1.1.1) Self-Supporting Film Region and Supported Region

The pellicle film 11C has a self-supporting film region RA and a supported region RB in a planar view, as illustrated in FIG. 13.

The self-supporting film region RA contains an exposing region RA1 and a peripheral border region RA2 in a planar view, as illustrated in FIG. 13. The peripheral border region RA2 surrounds the exposing region RA1 in the pellicle film 11C. The exposing region RA1 and the peripheral border region RA2 are adjacent in the third embodiment of the disclosure.

The peripheral border region RA2 has a pair of first center regions RA22 and a pair of second center regions RA23. The support frame 12C is a square frame formed by a pair of first side portions 124 and a pair of second side portions 125. The pair of first center regions RA22 is formed along the first side portions 124 in a first extending direction (X-axis direction) in which the first side portions 124 extend. The pair of first center regions RA23 is formed along the second side portions 125 in a second extending direction (Y-axis direction) in which the second side portions 125 extend.

The pair of first center regions RA22 indicates a region between two locations E3 and E4 apart by a distance L9 (see FIG. 13) representing at least 5% of a length L1 (see FIG. 13), in the opening H12C, of each of the first side portions 124, toward each of one direction and another direction from a center portion 1240 of each of the first side portions 124 in the first extending direction (X-axis direction), in the peripheral border region RA2.

The pair of first center regions RA23 indicates a region between two locations E5 and E6 apart by a distance L9 (see FIG. 13) representing at least 5% of a length L1 (see FIG. 13), in the opening H12C, of each of the second side portions 125, toward each of one direction and another direction from a center portion 1250 of each of the second side portions 125 in the second extending direction (Y-axis direction), in the peripheral border region RA2.

The distance L9 corresponds to 5% or more with respect to the length L1, in the opening H12C, of each of the first side portions 124, or with respect to the length L1 in the opening H12C, of each of the second side portions 125, and preferably corresponds to from 7% to 50%, more preferably from 10% to 45% from the viewpoint of suppression of breakage of the pellicle film 11C due to the pressure difference inside and outside of the pellicle 10C.

### (3.1.1.2) Film Thickness of Pellicle Film

The peripheral border region RA2 of the pellicle film 11C has four thick film portions TC thicker in film thickness than that of the exposing region RA1. In the third embodiment, the four thick film portions TC are respectively located in the pair of first center regions RA22 and the pair of second center regions RA23 in the peripheral border region RA2. Thus, mechanical strength of each of the pair of first center regions RA22 and the pair of second center regions RA23 is higher than mechanical strength of the exposing region RA1. In the third embodiment, stress to the pellicle film, generated due to the pressure difference inside and outside of the pellicle, is easily increased in the first center regions RA22 and the pair of second center regions RA23. As a result, the pellicle film 11C can be suppressed in breakage of the pellicle film 11C due to the pressure difference inside and outside of the pellicle 10C, as compared with a configuration in which the film thicknesses of the pair of first center regions RA22 and the pair of second center regions RA23 are each the same as the film thickness of the exposing region RA1. In particular, the thick film portions TC are provided so as to step across an edge portion of the support frame 12C from the peripheral border region RA2 toward an outer edge of the support frame 12C, whereby breakage of the pellicle film 11C due to stress concentration to the pellicle film 11C on the edge portion of the support frame 12C can be easily suppressed.

The ratio of each of the film thicknesses of the pair of first center regions RA22 and the pair of second center regions RA23 (namely, the film thicknesses of the thick film portions TC) to the film thickness of the exposing region RA1 is preferably from 1.5 times to 100 times. Thus, not only breakage of the pellicle film 11C due to the pressure difference inside and outside of the pellicle 10C can be more suppressed, but also production cost is excellent.

The lower limit of the ratio of each of the film thicknesses of the pair of first center regions RA22 and the pair of second center regions RA23 to the film thickness of the exposing region RA1 is more preferably 1.9 times or more, still more preferably 5 times or more, particularly preferably 10 times or more from the viewpoint of further suppression of breakage of the pellicle film 11C due to the pressure difference inside and outside of the pellicle 10C.

The upper limit of the ratio of each of the film thicknesses of the pair of first center regions RA22 and the pair of second center regions RA23 to the film thickness of the exposing region RA1 is preferably 70 times or less, more preferably 50 times or less from the viewpoint of production cost.

The thick film portions TC may be at least located in the pair of first center regions RA22 and the pair of second center regions RA23, may be located in only the pair of first center regions RA22 and the pair of second center regions RA23, or may be further located in, in addition to the pair of first center regions RA22 and the pair of second center regions RA23, a region different from the pair of first center regions RA22 and the pair of second center regions RA23.

### (3.1.1.3) Method of Measuring Film Thickness

The methods of measuring the film thickness of the exposing region RA1 and the film thicknesses of the pair of first center regions RA22 and the pair of second center regions RA23 are the same as the method of measuring each of the film thickness of the exposing region RA1 and the film thickness of the peripheral border region RA2 of the pellicle film 11A.

### (3.1.1.4) Structure of Pellicle Film

The structure of the pellicle film 11C is not particularly limited, and may be a single-layer structure or a layered structure. In particular, the structure of the pellicle film 11C is preferably a layered structure from the viewpoint of, for example, ease of production of the pellicle film 11C. The layered structure is, for example, a layered body of a first film portion (hereinafter, also referred to as "unprocessed film") and four fourth film portions (hereinafter, also referred to as "four third processed films"). The four third processed films are flat films containing a region corresponding to the pair of first center regions RA22 and the pair of second center regions RA23. The unprocessed film and the four third processed films each may be a single-layer film or may be a layered film in which a plurality of single-layer films is layered. The respective materials in the plurality of single-layer films may be the same as or different from each other.

The four third processed films may be located on a surface of the pellicle film 11C, in which the surface faces the support frame 12C, or may be located on a surface of the pellicle film 11C, in which the surface is opposite to the support frame 12C. In particular, the four third processed films are preferably layered on a surface of the unprocessed film, in which the surface faces the support frame 12C, from the viewpoint of, for example, preventing foreign substances from entering the opening H12C through an inner peripheral wall of the through-hole of each of the third processed films. That is, the four third processed films are preferably located on a surface of the pellicle film 11C, in which the surface is opposite to the support frame 12C. In other words, the support frame 12C, the unprocessed film, and the four third processed films are preferably placed in the listed order in the upper direction (Z-axis positive direction) from the lower direction (Z-axis negative direction). Such foreign substances entering through the four third processed films include fibers waste of the four third processed films.

### (3.1.1.5) Material of Pellicle Film

The material of the pellicle film 11C is not particularly limited, and examples thereof include each material exemplified as the material of the pellicle film 11A.

In a case in which the pellicle film 11C has a layered structure, the material of the unprocessed film and the material of the pair of second processed films may be the same as or different from each other.

In particular, the material of the pellicle film 11C preferably includes a carbon nanotube. The pellicle film 11C is a CNT film, whereby favorable mechanical strength can be obtained.

### (3.1.1.5.1) Antioxidant Layer

Other layer may be layered on the pellicle film 11C.

An antioxidant layer may be layered on at least one surface of the pellicle film 11C. Examples of the antioxidant layer include the same as those exemplified for the antioxidant layer that may be layered on the pellicle film 11A.

In a case in which the pellicle film 11C includes a CNT film and other layer is layered on the CNT film, the film thickness of the CNT film is thicker than the film thickness of such other layer.

In a case in which the pellicle film 11C includes a CNT film and other layer is layered on the CNT film, the outermost layer among layers constituting the pellicle film 11C is preferably such other layer.

In a case in which the pellicle film 11C includes a CNT film and other layer is layered on the CNT film, another aspect is such that the film thickness of the CNT film with respect to the film thickness of the entire pellicle film 11C including such other layer is preferably 50% or more, still more preferably 70% or more.

### (3.1.1.6) Physical Properties of Pellicle Film

Physical properties of the pellicle film 11C preferably include physical properties that are the same as physical properties exemplified as physical properties of the pellicle film 11A.

### (3.1.2) Support Frame

The support frame 12C is the same as the support frame 12A except that the shape of the frame is different.

The support frame 12C is a tubular product. The support frame 12C is a square frame formed by a pair of first side portions 124 and a pair of second side portions 125, in a planar view. The support frame 12C has the opening H12C. The opening H12C is a through-hole for EUV exposure. EUV light penetrating the exposing region RA1 of the pellicle film 11C in EUV exposure passes through the opening H12C and reaches an original plate.

### (3.1.3) Variation

The pellicle film 11C may have a first film portion and a second film portion. The first film portion has no through-hole. The second film portion has no film portion in a region corresponding to the exposing region RA1. The second film portion is layered on a surface of the first film portion, in which the surface is in a region (namely, pair of first center regions RA22 and pair of second center regions RA23) corresponding to the thick film portions TC of the first film portion and is opposite to the support frame 12A.

The first film portion is the same as that exemplified as the first film portion 11A1 (see FIG. 10) in the variation of the first embodiment. The second film portion is the same as that exemplified as the second film portion 11A2 (see FIG. 10) in the variation of the first embodiment except that the second film portion is layered on a region (namely, pair of first center regions RA22 and pair of second center regions RA23) corresponding to the thick film portions TC of the first film portion.

### (3.2) Exposure Original Plate

An exposure original plate according to the third embodiment of the disclosure includes an original plate and the pellicle 10C mounted on the original plate.

The exposure original plate according to the third embodiment of the disclosure includes the pellicle 10C, and thus exerts the same effect as in the pellicle 10C.

The exposure original plate according to the third embodiment of the disclosure is the same as the exposure original plate according to the first embodiment of the disclosure except that the pellicle 10C is used instead of the pellicle 10A.

### (3.3) Exposure Device

An exposure device according to the third embodiment of the disclosure includes a light source, the exposure original plate according to the third embodiment of the disclosure, and an optical system. The light source emits exposure light. The optical system guides exposure light emitted from the light source, to the exposure original plate. The exposure original plate is placed so that the exposure light emitted from the light source penetrates the pellicle film 11C and the original plate is irradiated with the exposure light.

Thus, the exposure device according to the third embodiment of the disclosure exerts the same effect as in the exposure original plate according to the third embodiment of the disclosure.

The exposure device according to the third embodiment of the disclosure is the same as the exposure device according to the first embodiment except that the exposure original plate according to the third embodiment of the disclosure is used instead of the exposure original plate according to the first embodiment of the disclosure.

### (3.4) Method of Producing Pellicle

Examples of the method of producing the pellicle according to the second embodiment of the disclosure include a fifth production method and a sixth production method.

Hereinafter, the fifth production method and the sixth production method will be described in the listed order.

### (3.4.1) Fifth Production Method

The fifth production method of the disclosure is
a method of producing the pellicle 10C, including
a step of preparing the support frame 12C,
a step of preparing a first film,
a step of preparing a second film,
a first connection step of connecting the support frame 12C to a portion of one main surface of the first film, and
a layering step of layering the second film on at least a region of other main surface of the first film, the region corresponding to the pair of first center regions RA22 and the pair of second center regions RA23 (namely, thick film portions TC), to form the pellicle film 11C.

According to the fifth production method, the pellicle 10C, in which breakage of the pellicle film 11C due to the pressure difference inside and outside of the pellicle 10C can be suppressed, is obtained.

The fifth production method of the disclosure is the same as the first production method of the disclosure except for layering the second film on at least a region of other main surface of the first film, the region corresponding to the pair of first center regions RA22 and the pair of second center regions RA23 (namely, thick film portions TC), instead of layering the second film on at least a region of other main surface of the first film, the region corresponding to the peripheral border region RA2 (namely, thick film portion TA).

### (3.4.2) Sixth Production Method

The sixth production method of the disclosure is
a method of producing the pellicle 10C, including
a step of preparing the support frame 12C,
a step of preparing the pellicle film 11C, and
a second connection step of connecting the support frame 12C to the pellicle film 11C.

According to the sixth production method of the disclosure, the pellicle 10C, in which breakage of the pellicle film 11C due to the pressure difference inside and outside of the pellicle 10C can be suppressed, is obtained.

The sixth production method of the disclosure is the same as the second production method of the disclosure except for preparing the pellicle film 11C instead of preparing the pellicle film 11A.

A method of preparing the pellicle film 11C is not particularly limited. For example, the pellicle film 11C may have a carbon nanotube and the thick film portions TC (namely, pair of first center regions RA22 and pair of second center regions RA23) may be formed by a spray coating method or an ink-jet method.

The spray coating method or the ink-jet method may be a known method.

### (3.5) Method of Producing Semiconductor Device

A method of producing a semiconductor device according to the third embodiment of the disclosure includes a reflection step and an exposure step. In the reflection step, exposure light emitted from a light source is allowed to penetrate the pellicle film 11C of an exposure original plate, to irradiate the original plate with the exposure light and reflect the exposure light by the original plate. In the exposure step, the exposure light reflected by the original plate is allowed to penetrate the pellicle film 11C, to irradiate a sensitive substrate with the exposure light, thereby exposing the sensitive substrate in a pattern shape. The reflection step and the exposure step are carried out in the listed order.

According to the method of producing a semiconductor device according to the third embodiment of the disclosure, a semiconductor device reduced in resolution failure due to foreign substances is obtained even in the case of use of EUV light easily causing the problem of resolution failure due to foreign substances.

The method of producing a semiconductor device according to the third embodiment of the disclosure is the same as the method of producing a semiconductor device according to the first embodiment of the disclosure except that the pellicle film 11C is used instead of the pellicle film 11A.

### EXAMPLES

Hereinafter, the disclosure will be more specifically described with reference to Examples and the like, but the invention of the disclosure is not limited to only these Examples.

In the present Examples, the film thickness of an exposing region and the film thickness of a peripheral border region were each measured by the above method.

### [1] Example 1

In Example 1, a pellicle in which a support frame 120 was a rectangular frame and a thick film portion was located in the whore area of a peripheral border region RC2 was produced as follows. In the pellicle of Example 1, a CNT film was in contact with the support frame 120 and covered the whore area of an opening H120 of the support frame 120.

### [1.1] Preparation Step

CNT here prepared was single-layer CNT synthesized by an enhanced direct injection pyrolytic synthesis method (eDIPS method) (crude CNT, manufactured by Meijo Nano Carbon, trade name: EC1.5-P, tube size: from 1 nm to 3 nm, tube length: 100 nm or more).

### [1.2] CNT Dispersion Liquid Production Step

A CNT dispersion liquid was obtained by adding 70 mL of isopropyl alcohol and 30 mL of ethanol to 30 mg of the single-layer CNT synthesized by an enhanced direct injection pyrolytic synthesis method (eDIPS method), further adding 30 mg of polyacrylic acid as an additive, and stirring the resultant with a magnetic stirrer at 1000 rpm (revolutions per minute) and at 40°C for 18 hours.

### [1.3] CNT Film Production Step

A silicon wafer of a size of 8 inches (hereinafter, also referred to as "silicon substrate") was prepared. The silicon substrate was spin coated with the CNT dispersion liquid at a rotational speed of 1500 rpm, and a thin film 110A of CNT (hereinafter, also referred to as "CNT film 110A") was obtained on the silicon substrate. The size of the CNT film 110A was larger than that of a square having a length of each side of 10 mm.

Hereinafter, the silicon substrate and the CNT film 110A formed on the silicon substrate are also collectively referred to as "film-attached substrate (A)".

After the CNT film 110A was washed with water, to remove polyacrylic acid in the CNT film 110A, and drying was made, the film-attached substrate (A) was dipped in water. Next, only the CNT film 110A was allowed to remain in water and only the silicon substrate was taken out from water, whereby the CNT film 110A was released from the silicon substrate, and the CNT film 110A, which had a network structure, was produced in the state of floating on a water liquid surface.

### [1.4] Placement

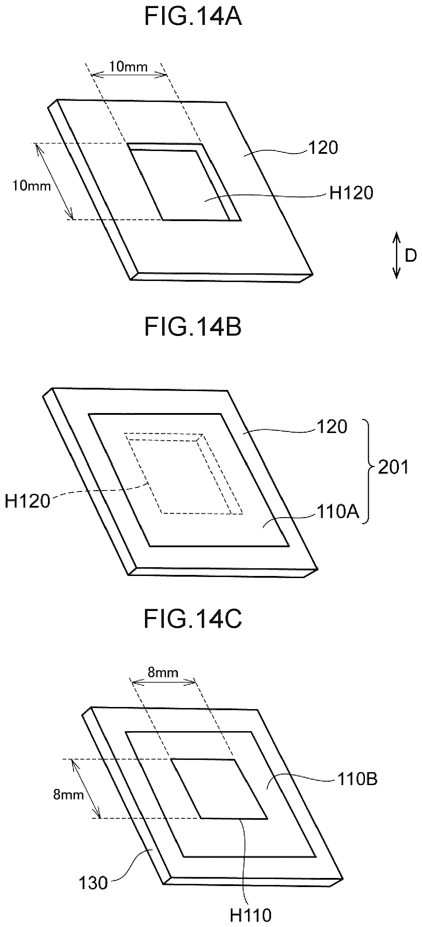

A silicon frame 120 (hereinafter, also referred to as "support frame 120") as illustrated in FIG. 14A was prepared as the support frame. The support frame 120 was a tubular product. The support frame 120 had an opening H120. The opening H120 passed through the support frame 120 along with a thickness direction D of the support frame 120. The profile of the opening H120, viewed from one direction of the thickness direction D of the support frame 120, was a square having a length of each side of 10 mm.

The CNT film 110A in the state of floating on a water liquid surface was taken up by the support frame 120, whereby the CNT film 110A was placed on the support frame 120 as illustrated in FIG. 14B, to obtain a first specimen 201. The CNT film 110A was in contact with the support frame 120, and covered the whore area of the opening H120 of the support frame 120.

The above preparation step, CNT dispersion liquid production step, and CNT film production step were carried out, to obtain a new film-attached substrate (A). A CNT film 110A of the film-attached substrate (A) obtained was mechanically scrubbed, whereby a through-hole H110 was formed on the CNT film 110A, as illustrated in FIG. 14C, to obtain a CNT film 110B. The through-hole H110 of the CNT film 110B was formed along with a thickness direction of the CNT film 110B. The profile of the through-hole of the CNT film 110B, viewed from one direction of the thickness direction of the silicon substrate 130, was a square having a length of each side of 8 mm.

Hereinafter, the silicon substrate 130 and the CNT film 110B formed on the silicon substrate 130 are also collectively referred to as "film-attached substrate (B)".

After the CNT film 110B was washed with water, to remove polyacrylic acid in the CNT film 110B, and the film-attached substrate (B) was dried, the film-attached substrate (B) was dipped in water. Next, the CNT film 110B was allowed to remain in water and only the silicon substrate 130 was taken out from water, whereby the CNT film 110B was released from the silicon substrate 130.

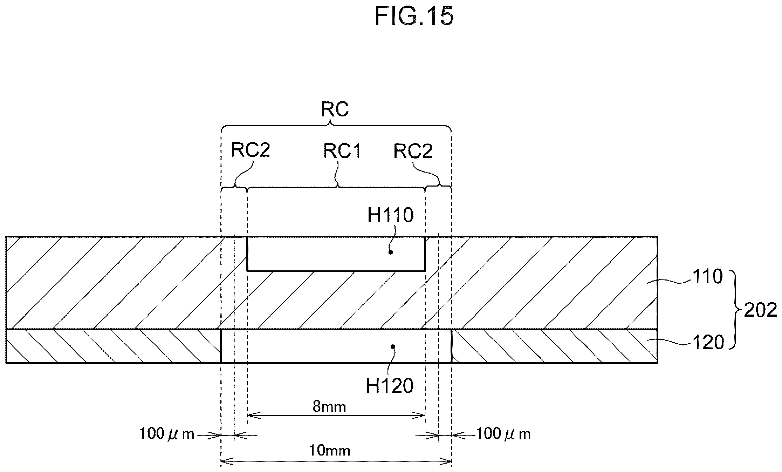

The CNT film 110B was taken up by the first specimen 201 (see FIG. 14B), whereby the CNT film 110B was placed on the CNT film 110A, to form a pellicle film 110, thereby obtaining a second specimen 202 illustrated in FIG. 15, as a pellicle.

The second specimen 202 included the pellicle film 110 and a support frame 120. The pellicle film 110 had a self-supporting film region RC covering an opening H120 of the support frame 120. The self-supporting film region RC included an exposing region RC1 and a peripheral border region RC2. The peripheral border region RC2 surrounded the exposing region RC1.

The film thickness of the exposing region RC1 and the film thickness of the peripheral border region RC2 of the second specimen 202 were each measured by the above method. The film thickness of the exposing region RC1 of the second specimen 202 was 15 nm. The film thickness of the peripheral border region RC2 of the second specimen 202 was 30 nm.

### [2] Comparative Example 1

A first specimen 201 was obtained as a pellicle in the same manner as in Example 1. A CNT film 110A in Comparative Example 1 corresponded to a pellicle film 110.

The film thickness of an exposing region RC1 and the film thickness of a peripheral border region RC2 of the first specimen 201 were each measured by the above method. The film thickness of the exposing region RC1 of the first specimen 201 was 15 nm. The film thickness of the peripheral border region RC2 of the second specimen 201 was 15 nm.

### [3] Evaluation

### [3.1] Breaking Evaluation by Bulge Test

Each of the pellicles obtained in Example 1 and Comparative Example 1 was subjected to breaking evaluation by a bulge test of the pellicle film 110.

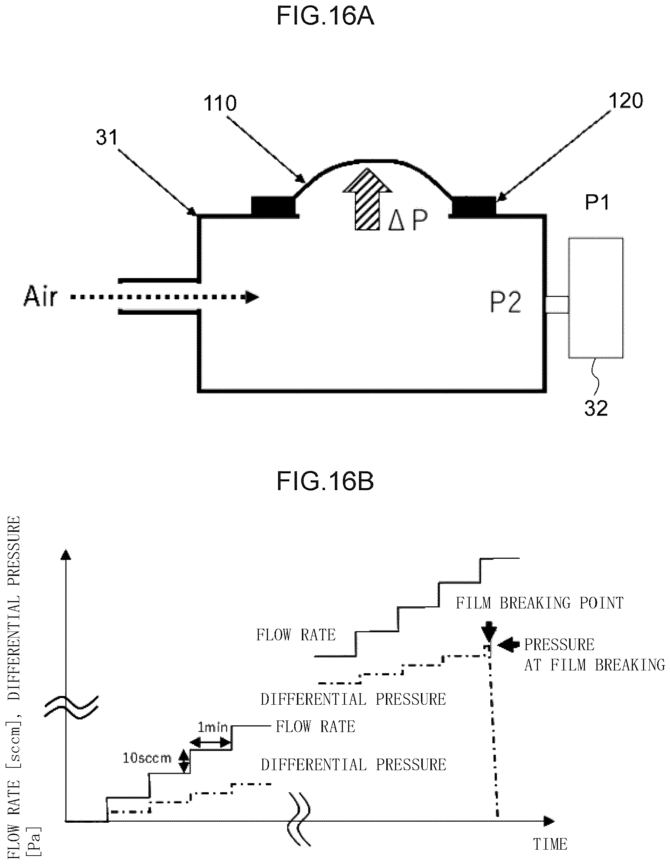

Each of the pellicles was secured to a chamber 31 for a bulge test, as illustrated in FIG. 16A. The pellicle film 110 was placed so as to be inside the chamber 31.

Compressed air flowed in the chamber 31, to allow the inside of the chamber 31 to be in a pressurized state, and a pressure ΔP was applied to the self-supporting film region RC of the pellicle film 110.

The pressure ΔP applied to the pellicle film 110 was represented by the difference between a pressure (atmospheric pressure) P1 outside the chamber 31 and a pressure P2 inside the chamber 31, and was measured with a differential pressure gauge 32. The ΔP was adjusted by controlling the flow rate of compressed air flowing inside the chamber 31, with a flowmeter (not illustrated).

The flow rate of air flowing inside the chamber 31 was increased by 10 sccm at an interval of 1 minute, as illustrated in FIG. 16B, and the differential pressure ΔP generated here was recorded. In a case in which the pellicle film 110 was broken, the differential pressure ΔP was remarkably reduced because of formation of a hole in the pellicle film 110. The "pressure at film breaking" was measured from the value of the differential pressure ΔP immediately before breaking of the pellicle film 110.

The measurement results of the pressure at breaking are shown in Table 2.

**[Table 2]**

| | Self-supporting film region | | | Bulge test | |
|---|---|---|---|---|---|
| | Film thickness of peripheral border region (Film thickness of thick film portion) (nm) | Film thickness of exposing region (nm) | Film thickness ratio | Pressure at film breaking (PA) | Evaluation |
| Example 1 | 30 | 15 | 2.0 | 250 | A |
| Comparative Example 1 | 15 | 15 | 1.0 | 131 | B |

In Table 2, "Film thickness ratio" represents the ratio of the film thickness of the peripheral border region RC2 (thick film portion) with respect to the film thickness of the exposing region RC1.

In Table 2, "A" indicates that breakage of the pellicle film 110 due to the pressure difference inside and outside of the pellicle can be suppressed with the film thickness of the exposing region RC1 being kept.

In Table 2, "B" indicates that breakage of the pellicle film 110 due to the pressure difference inside and outside of the pellicle cannot be suppressed with the film thickness of the exposing region RC1 being kept.

As shown in Table 2, the pellicle of Example 1 includes a support frame 120 having an opening H120, and a pellicle film 110 that covers the opening H120 and that is supported by the support frame 120. The pellicle film 110 has a self-supporting film region RC covering the opening H120. The self-supporting film region RC contains an exposing region RC1, and a peripheral border region RC2 surrounding the exposing region RC1. The peripheral border region RC2 has a thick film portion thicker in film thickness than that of the exposing region RC 1. The support frame 120 is a rectangular frame. The thick film portion is located in the whore area of the peripheral border region RC2.

Thus, in a case in which the film thickness of the pellicle of Example 1, namely, the peripheral border region RC2 was thicker than the film thickness of the exposing region RC1, the pressure at film breaking was 250 Pa.

In this regard, in a case in which the film thickness of the pellicle of Comparative Example 1, namely, the peripheral border region RC2 was not thicker than the film thickness of the exposing region RC1, the pressure at film breaking was 131 Pa. It was found from these results that the film thickness of the peripheral border region RC2 was thicker than the film thickness of the exposing region RC1, whereby breakage of the pellicle film due to the pressure difference inside and outside of the pellicle could be suppressed with the film thickness of the exposing region RC1 being kept (in the state of the transmittance of EUV light being kept).

### [4] Example 2

In Example 2, a pellicle in which a support frame 120 was a square frame and a thick film portion TX was located on a center portion of each of four sides of the support frame 120 was produced as follows. In the pellicle of Example 2, a pellicle film 111 was in contact with the support frame 120 and covered the whore area of an opening H120 of the support frame 120, as in Example 1.

### [4.1] Preparation Step, CNT Dispersion Liquid Production Step, and CNT Film Production Step

The preparation step, CNT dispersion liquid production step, and CNT film production step of Example 1 were carried out, to obtain a new plurality of film-attached substrates (A).

Some of the plurality of film-attached substrates (A) was washed with water and dipped in water in the same manner as in Example 1, whereby a CNT film 110A was produced.

### [4.2] Placement

A first specimen 201 (see FIG. 13B) was obtained by taking up the CNT film 110A by the support frame 120 as in the placement of Example 1.

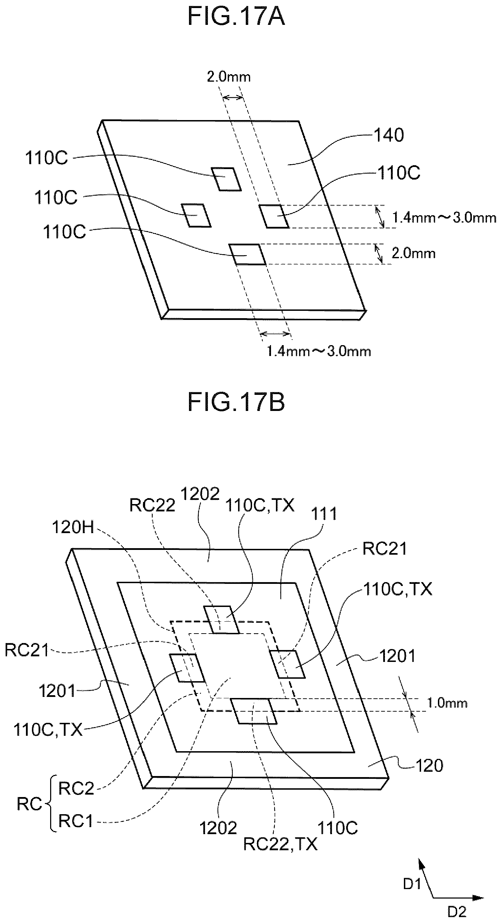

The CNT film 110A of the film-attached substrate (A) obtained was mechanically scrubbed, whereby four CNT films 110C were obtained, as illustrated in FIG. 17A. The CNT films 110C each had an oblong shape in which the length and the width of a pair of sides in one direction were respectively from 1.4 mm to 3.0 mm and 2.0 mm, and the length and the width of a pair of sides in other direction were respectively from 1.4 mm to 3.0 mm and 2.0 mm.

Hereinafter, the silicon substrate 140 and the four CNT films 110C formed on the silicon substrate 140 are also collectively referred to as "film-attached substrate (C)".

After the four CNT films 110C were washed with water, to remove polyacrylic acid in the CNT films 110C, and the film-attached substrate (C) was dried, the film-attached substrate (C) was dipped in water. Next, the four CNT films 110C were allowed to remain in water and only the silicon substrate 140 was taken out from water, whereby the CNT films 110C were released from the silicon substrate 140.

The four CNT films 110C were taken up by the first specimen 201 (see FIG. 12B), and placed on a center portion of a pair of first sides and a center portion of a pair of second sides of the support frame, to form a pellicle film 111. Thus, a specimen 203 illustrated in FIG. 17B was obtained as a pellicle.

The specimen 203 included the pellicle film 111 and a support frame 120.

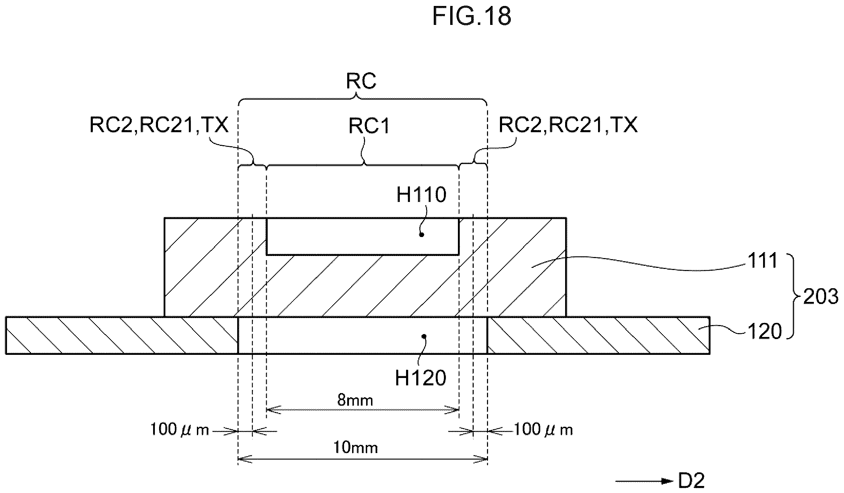

The pellicle film 111 of the specimen 203 had a self-supporting film region RC covering an opening H120 of the support frame 120, as illustrated in FIG. 18. The self-supporting film region RC included an exposing region RC1 and a peripheral border region RC2. The peripheral border region RC2 surrounded the exposing region RC1.

The peripheral border region RC2 had four thick film portions TX. The support frame 120 was a square frame formed by a pair of first side portions 1201 and a pair of second side portions 1202. The length of the first side portion 1201 and the length of the second side portion 1202 were the same. Two of the thick film portions TX were located in a pair of first center regions RC21 formed along the pair of first side portions 1201 in a first extending direction D1 in which the first side portions 1201 extended, in the peripheral border region RC2. Two of the thick film portions TX were located in a pair of second center regions RC22 formed along the pair of second side portions 1202 in a second extending direction D2 in which the second side portions 1202 extend, in the peripheral border region RC2.

The average value of the side coverages of the four thick film portions TX was 13%. The maximum value of the side coverages of the four thick film portions TX was 15%. The minimum value of the side coverages of the four thick film portions TX was 11%.

"Side coverage" of each of the thick film portions TX formed along the pair of first side portions 1201 represents the proportion of a first length with respect to the length of the opening H120 in the first side portion 1201 of the support frame 120 in the first extending direction D1. "First length" represents the shorter length between the length from a center portion of the first side portion 1201 to one end portion of each of the thick film portions TX and the length from the center portion of the first side portion 1201 to other end portion of each of the thick film portions TX, in the first extending direction D1.

"Side coverage" of each of the thick film portions TX formed along the pair of second side portions 1202 represents the proportion of a second length with respect to the length of the opening H120 in the second side portion 1202 of the support frame 120 in the second extending direction D2. "Second length" represents the shorter length between the length from a center portion of the second side portion 1202 to one end portion of each of the thick film portions TX and the length from the center portion of the second side portion 1202 to other end portion of each of the thick film portions TX, in the second extending direction D2.

For example, in a case in which each of the thick film portions TX is present in a region between a location apart by 13% of the length of the opening H120 in one direction and a location apart by 13% of the length of the opening H120 in other direction, from the center portion of the first side portion 1201 in the first extending direction D1 (in other words, in a case in which each of the thick film portions TX is located in the first center region RC21 having a length corresponding to 26% with respect to the length of the opening H120 in the first extending direction D1), the coverage is 13%.

The film thickness of the exposing region RC1 and the film thickness of the peripheral border region RC2 of the specimen 203 were each measured by the above method. The film thickness of the exposing region RC1 of the specimen 203 was 23 nm. The film thicknesses of the thick film portions TX in the peripheral border region RC2 of the specimen 203 were each 47 nm and the film thickness of a region not corresponding to these thick film portions TX was 23 cm.

### [5] Example 3

A specimen 203 was obtained in the same manner as in Example 2 except that the film thickness of the peripheral border region, the film thickness of the exposing region, and the like were changed as shown in Table 3.

### [6] Comparative Example 2

A first specimen 201 was obtained as a pellicle in the same manner as in Example 2. A CNT film 110A in Comparative Example 2 corresponded to a pellicle film 110.

The film thickness of an exposing region RC1 and the film thickness of a peripheral border region RC2 of the first specimen 201 were each measured by the above method. The film thickness of the exposing region RC1 of the first specimen 201 was 24 nm. The film thickness of the peripheral border region RC2 of the second specimen 201 was 24 nm.

### [7] Evaluation

### [7.1] Breaking Evaluation by Bulge Test

Each of the pellicles of Example 2, Example 3, and Comparative Example 2 was subjected to film breaking evaluation of the pellicle in the same manner as in the above breaking evaluation by a bulge test. The measurement results of the pressure at breaking are shown in Table 3.

**[Table 3]**

| | Self-supporting film region | | | | | | | Bulge test | |
|---|---|---|---|---|---|---|---|---|---|
| | Film thickness of peripheral border region | | Film thickness of exposing region (nm) | Film thicknes s ratio | Side coverage (%) | | | Pressure at film breaking (PA) | Evaluatio n |
| | Thick film portion (nm) | Site other than thick film portion (nm) | | | Average | Maximum | Minimu m | | |
| Exa mpl e2 | 48 | 24 | 24 | 2.0 | 13 | 15 | 11 | 468 | A |
| Exa mpl e 3 | 47 | 23 | 23 | 2.0 | 10 | 12 | 7 | 424 | A |
| Co mpa rativ e Exa mpl e2 | 24 | 24 | 24 | 1.0 | 0 | 0 | 0 | 310 | B |

In Table 3, "Film thickness ratio" represents the ratio of each of the film thicknesses of the thick film portions TX of the peripheral border region RC2 with respect to the film thickness of the exposing region RC1.

In Table 3, "Side coverage" represents the proportion of a place having each of the thick film portions TX with respect to the length of the opening H120 of the first side portion 1201 in the first extending direction D1, or the proportion of a place having each of the thick film portions TX with respect to the length of the opening H120 of the second side portion 1202 in the second extending direction D2.

In Table 3, "Average" in "Side coverage" represents the average value of the side coverages of the four thick film portions TX.

In Table 3, "Maximum" in "Side coverage" represents the maximum value of the side coverages of the four thick film portions TX.

In Table 3, "Minimum" in "Side coverage" represents the minimum value of the side coverages of the four thick film portions TX.

In Table 3, "A" indicates that breakage of the pellicle film 111 due to the pressure difference inside and outside of the pellicle (namely, specimen 203) can be suppressed with the film thickness of the exposing region RC1 being kept.

In Table 3, "B" indicates that breakage of the pellicle film 111 due to the pressure difference inside and outside of the pellicle (namely, specimen 203) cannot be suppressed with the film thickness of the exposing region RC1 being kept.

As shown in Table 3, each of the pellicles of Example 2 and Example 3 includes a support frame 120 having an opening H120, and a pellicle film 111 that covers the opening H120 and that is supported by the support frame 120. The pellicle film 111 has a self-supporting film region RC covering the opening H120. The self-supporting film region RC contains an exposing region RC1, and a peripheral border region RC2 surrounding the exposing region RC1. The peripheral border region RC2 has a thick film portion TX thicker in film thickness than the film thickness of the exposing region RC1. The support frame 120 is a rectangular frame. Two such thick film portions TX are located in a pair of first center regions RC21. Two such thick film portions TX are located in a pair of second center regions RC22.

Thus, in a case in which the film thicknesses of the pellicles of Example 2 and Example 3, namely, the first center region RC21 and second center region RC22 were thicker than the film thickness of the exposing region RC1, the pressure at film breaking was 424 Pa or more.

In this regard, in a case in which the film thickness of the pellicle of Comparative Example 2, namely, each of the first center region RC21 and the second center region RC22 was not thicker than the film thickness of the exposing region RC 1, the pressure at film breaking was 310 Pa. It was found from these results that, in a case in which the support frame 120 was a square frame, the film thicknesses of the first center region RC21 and the second center region RC22 were thicker than the film thickness of the exposing region RC1, whereby breakage of the pellicle film due to the pressure difference inside and outside of the pellicle could be suppressed with the film thickness of the exposing region RC1 being kept (in the state of the transmittance of EUV light being kept).

The disclosure of Japanese Patent Application No. 2021-061642 filed on March 31, 2021 is herein incorporated by reference in its entirety.

All documents, patent applications, and technical standards described herein are herein incorporated by reference, as if each individual document, patent application, and technical standard were specifically and individually indicated to be incorporated by reference.

## Claims

1. A pellicle comprising:
a support frame having an opening; and
a pellicle film that covers the opening and that is supported by the support frame, wherein:
the pellicle film has a self-supporting film region covering the opening,
the self-supporting film region contains an exposing region and a peripheral border region surrounding the exposing region,
the peripheral border region has a thick film portion having a thicker film thickness than a film thickness of the exposing region, and
the following (i) or (ii) is satisfied:
(i) the support frame is a rectangular frame formed by a pair of longer side portions and a pair of shorter side portions,
the thick film portion is located in at least a pair of longer side regions formed along the longer side portions, in the peripheral border region, in an extending direction in which the longer side portions extend, and
the pair of longer side regions is a region between two locations apart by a distance representing at least 5% of a length, in the opening, of each of the longer side portions, toward each of one direction and another direction from a center portion of each of the longer side portions in the extending direction, in the peripheral border region;
(ii) the support frame is a square frame formed from a pair of first side portions and a pair of second side portions,
the thick film portion is, in the peripheral border region, located in at least:
a pair of first center regions formed along the first side portions in a first extending direction in which the first side portions extend, and
a pair of second center regions formed along the second side portions in a second extending direction in which the second side portions extend;
the pair of first center regions is a region between two locations apart by a distance representing at least 5% of a length, in the opening, of each of the first side portions, toward each of one direction and another direction from a center portion of each of the first side portions in the first extending direction, in the peripheral border region, and
the pair of second center regions is a region between two locations apart by a distance representing at least 5% of a length, in the opening, of each of the second side portions, toward each of one direction and another direction from a center portion of each of the second side portions in the second extending direction, in the peripheral border region.

2. The pellicle according to claim 1, wherein (i) is satisfied.

3. The pellicle according to claim 1, wherein (ii) is satisfied.

4. The pellicle according to any one of claims 1 to 3, wherein the film thickness of the thick film portion is from 1.5 times to 100 times the film thickness of the exposing region.

5. The pellicle according to any one of claims 1 to 4, wherein the pellicle film comprises a carbon nanotube.

6. The pellicle according to any one of claims 1 to 5, wherein the support frame is in contact with the pellicle film.

7. The pellicle according to any one of claims 1 to 6, wherein:
the pellicle film contains a first film portion having no through-hole, and a second film portion having no film portion in a region corresponding to the exposing region,
the first film portion contains a first CNT layer containing a carbon nanotube,
the second film portion contains a second CNT layer containing a carbon nanotube, and
a total thickness of the first CNT layer and the second CNT layer in the thick film portion is from 1.5 times to 100 times a thickness of the first CNT layer in the exposing region.

8. The pellicle according to claim 7, wherein the second film portion is layered on a surface of the first film portion, the surface being in a region corresponding to the thick film portion of the first film portion and being at an opposite side of the first film portion from the support frame.

9. An exposure original plate comprising:
an original plate; and
the pellicle according to any one of claim 1 to claim 8, mounted on the original plate.

10. An exposure device comprising:
a light source that emits exposure light;
the exposure original plate according to claim 9; and
an optical system that guides the exposure light emitted from the light source, to the exposure original plate,
wherein the exposure original plate is placed so that the exposure light emitted from the light source penetrates the pellicle film and the original plate is irradiated with the exposure light.

11. The exposure device according to claim 10, wherein the exposure light is EUV light.

12. A method of producing the pellicle according to any one of claims 1 to 8, comprising:
a step of preparing the support frame;
a step of preparing the pellicle film; and
a connection step of connecting the support frame to the pellicle film.

13. The method of producing the pellicle according to claim 12, wherein:
the pellicle film contains a carbon nanotube, and
the thick film portion is formed by a spray coating method or an ink-jet method, in the step of preparing the pellicle film.

14. A method of producing the pellicle according to any one of claims 1 to 8, comprising:
a step of preparing the support frame;
a step of preparing a first film;
a step of preparing a second film;
a connection step of connecting the support frame to a portion of one main surface of the first film; and
a layering step of layering the second film on another main surface of the first film, to form the pellicle film.

15. The method of producing the pellicle according to claim 14, wherein each of the first film and the second film comprises a carbon nanotube.

16. The method of producing the pellicle according to any one of claims 12 to 15, wherein the pellicle film comprises a layered film in which two or more CNT films each including a carbon nanotube are layered.

17. A method of producing a semiconductor device, comprising:
a step of allowing exposure light emitted from a light source to penetrate the pellicle film of the exposure original plate according to claim 9, to irradiate the original plate with the exposure light and reflect the exposure light by the original plate; and
a step of allowing the exposure light reflected by the original plate to penetrate the pellicle film, to irradiate a sensitive substrate with the exposure light, thereby exposing the sensitive substrate in a pattern shape.
